(19) Europäisches Patentamt
European Patent Office
Office européen des brevets

(11) **EP 2 433 185 B1**

(12) **EUROPÄISCHE PATENTSCHRIFT**

(45) Veröffentlichungstag und Bekanntmachung des Hinweises auf die Patenterteilung:
**08.05.2013 Patentblatt 2013/19**

(21) Anmeldenummer: **10741940.0**

(22) Anmeldetag: **05.08.2010**

(51) Int Cl.:
***G05B 17/02*** *(2006.01)*

(86) Internationale Anmeldenummer:
**PCT/EP2010/061450**

(87) Internationale Veröffentlichungsnummer:
**WO 2012/016596 (09.02.2012 Gazette 2012/06)**

(54) **VORRICHTUNG UND VERFAHREN ZUM BEARBEITEN EINER PROZESSSIMULATIONSDATENBASIS EINES PROZESSES**

APPARATUS AND METHOD FOR EDITING A PROCESS SIMULATION DATABASE FOR A PROCESS

DISPOSITIF ET PROCÉDÉ POUR LE TRAITEMENT D'UNE BASE DE DONNÉES DE SIMULATION D'UN PROCESSUS

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**28.03.2012 Patentblatt 2012/13**

(73) Patentinhaber: **Fraunhofer Gesellschaft zur Förderung der angewandten Wissenschaft E.V.
80686 München (DE)**

(72) Erfinder:
• **STEFFES-LAI, Daniela
50968 Köln (DE)**

• **NIKITINA, Lialia
53773 Hennef (DE)**
• **CLEES, Tanja
53225 Bonn (DE)**

(74) Vertreter: **Schenk, Markus et al
Schoppe, Zimmermann, Stöckeler & Zinkler
Patentanwälte
Postfach 246
82043 Pullach bei München (DE)**

(56) Entgegenhaltungen:
**US-A1- 2009 089 030**

## Beschreibung

Ausführungsbeispiele gemäß der Erfindung beziehen sich auf die Analyse von Prozessparameterschwankungen von Prozessen und insbesondere auf eine Vorrichtung und ein Verfahren zum Bearbeiten einer Prozesssimulationsdatenbasis eines Prozesses.

Die Robustheit von Produktionsprozessen und die Qualität resultierender Produkte können erheblich unter Schwankungen von Material-, Prozess- oder Geometrieparametern sowie externen Einflüssen leiden. Die Auswirkungen dieser Schwankungen zu analysieren und nach Möglichkeit zu minimieren ist eine herausfordernde Aufgabe und ein Ziel in der Produktentwicklung. Dies ist insbesondere der Fall, wenn ganze Ketten von (Herstellungs) Prozessen betrachtet werden. Die Historie des Prozesses in die Analyse des üblicherweise noch alleinig betrachteten letzten Kettenschrittes mit einzubeziehen, kann zu deutlichen Verbesserungen der Vorhersagequalität führen. Z.B. in der Prozesskette Umformen-Crash (Umformen-Unfall) aus der Automobilindustrie führt gerade für Bauteile mit einem potentiell kritischen Einfluss im Crash (Unfall), wie z.B. B-Säulen, die aus mehreren geformten und gefügten Teilen bestehen, eine statistische Analyse und komplette Übertragung aller lokalen Schwankungen über alle Prozessschritte hinweg, zu wertvollen Einsichten und Ergebnissen für die Produktentwicklung. US 2009/0089030 beschreibt ein System mit mehreren Simulations einheiten.

Um Schwankungen von Prozessparametern mit Hilfe von Prozesssimulationsdaten über mehrere Prozessschritte zu verfolgen, müssen jeweils die Ausgangsdaten der Prozesssimulation eines Prozesses auf die Voraussetzungen für Eingangsdaten des Folgeprozesses angepasst werden. Auch die Datenmenge muss in einem handhabbaren Rahmen gehalten werden. Trotzdem möchte man das Verhalten des Prozesses unter Schwankung der Prozessparameter möglichst genau abbilden.

Es ist die Aufgabe der vorliegenden Erfindung, ein verbessertes Konzept für die Bearbeitung einer Prozesssimulationsdatenbasis eines Prozesses für den Prozessparameterschwankungen mehrerer Prozessparameter berücksichtigt wurden, zu schaffen, das eine Reduktion der Datenmenge in der Prozesssimulationsdatenbasis und/oder eine genauere Berücksichtigung der Prozessparameterschwankungen ermöglicht. Diese Aufgabe wird durch eine Vorrichtung gemäß Anspruch 1 oder ein Verfahren gemäß Anspruch 28 gelöst.

Ein Ausführungsbeispiel gemäß der Erfindung schafft eine Vorrichtung zum Bearbeiten einer Prozesssimulationsdatenbasis eines Prozesses, die einen Prozessparameterklassifikator und einen Prozesssimulationsdatenbearbeiter aufweist. Die Prozesssimulationsdatenbasis des Prozesses umfasst dabei Prozesssimulationsdaten einer Mehrzahl von Prozesssimulationen des Prozesses, wobei jede Prozesssimulation der Mehrzahl von Prozesssimulationen auf einer unterschiedlichen Variation einer Mehrzahl von Prozessparametern basiert. Für jeden variierten Prozessparameter der Mehrzahl von variierten Prozessparametern sind für eine initiale Anzahl von unterschiedlichen Prozessparameterwerten Prozesssimulationsdaten einer Prozesssimulation in der Prozesssimulationsdatenbasis enthalten. Der Prozessparameterklassifikator berechnet für einen variierten Prozessparameter der Mehrzahl von variierten Prozessparametern einen Linearitätsindikator, basierend auf einer Analyse der Prozesssimulationsdatenbasis bezüglich einer Linearität eines Einflusses einer Variation zumindest des variierten Prozessparameters auf die Prozesssimulationsdaten in der Prozesssimulationsdatenbasis. Des Weiteren verändert der Prozesssimulationsdatenbearbeiter die initiale Anzahl von unterschiedlichen Prozessparameterwerten des variierten Prozessparameters, für die Prozesssimulationsdaten einer Prozesssimulation in der Prozesssimulationsdatenbasis enthalten sind, basierend auf dem berechneten Linearitätsindikator, um eine bearbeitete Prozesssimulationsdatenbasis zu erhalten.

Ausführungsbeispiele gemäß der Erfindung basieren auf dem Kerngedanken, die Menge an Prozesssimulationsdaten eines variierten Prozessparameters in Abhängigkeit des Verhaltens der Prozesssimulationsdaten unter Variation des betrachteten, variierten Prozessparameters zu verändern. Beispielsweise kann die initiale Anzahl von unterschiedlichen Prozessparameterwerten, für die Prozesssimulationsdaten in der Prozesssimulationsdatenbasis enthalten sind, reduziert werden, wenn der betrachtete Prozessparameter keinen Einfluss, einen vernachlässigbaren Einfluss, einen linearen Einfluss oder einen schwachen nicht-linearen Einfluss auf die Prozesssimulationsdaten hat. In anderen Worten, es können Prozesssimulationsdaten, die zu unterschiedlichen Prozessparameterwerten des betrachteten, variierten Prozessparameters gehören, aus der Prozesssimulationsdatenbasis entfernt werden, da das Verhalten der Prozesssimulationsdaten unter Variation des betrachteten Prozessparameters bereits durch wenige (z. B. durch ein oder zwei) unterschiedliche Prozessparameterwerte charakterisiert oder berücksichtigt werden kann. Dadurch kann die Datenmenge in der Prozesssimulationsdatenbasis deutlich verringert werden. Andererseits kann für betrachtete, variierte Prozessparameter, die sich z.B. stark nicht-linear auf die Prozesssimulationsdaten auswirken, die Anzahl von unterschiedlichen Prozessparameterwerten, für die Prozesssimulationsdaten in der Prozesssimulationsdatenbasis enthalten sind, auch erhöht werden, um das nicht-lineare Verhalten besser darzustellen. Dadurch kann die Genauigkeit der Berücksichtigung der Schwankungen der Prozessparameter deutlich erhöht werden.

Einige Ausführungsbeispiele gemäß der Erfindung beziehen sich auf eine Zuordnung eines Prozessparameters in eine erste linearitätsabhängige Klasse oder eine zweite linearitätsabhängige Klasse von Prozessparametern in Abhängigkeit des berechneten Linearitätsindikatoren. Dadurch können der Parameter nach seinem Einfluss auf die Prozesssimulationsdaten (z. B. linear, schwach nicht-linear, stark nicht-linear) in Klassen eingeteilt werden und unterschiedlich behandelt werden.

Andere Ausführungsbeispiele gemäß der Erfindung beziehen sich auf eine Zuordnung eines Prozessparameters in eine erste einflussabhängige Klasse von Prozessparametern und eine zweite einflussabhängige Klasse von Prozessparametern basierend auf einem Einflussstärkeindikator. Dadurch können Prozessparameter, die keinen oder nur einen minimalen Einfluss auf die Prozesssimulationsdaten (im betrachteten Variationsbereich der Prozessparameter) haben von Prozessparametern unterschieden werden, die einen hohen Einfluss auf die Prozesssimulationsdaten haben. Die Parameter in den unterschiedlichen Klassen können dann im weiteren Verlauf unterschiedlich behandelt werden.

Einige weitere Ausführungsbeispiele gemäß der Erfindung weisen Prozesssimulator auf, der den Prozess für eine Kombination von Prozessparameterwerten einen der Mehrzahl von variierten Prozessparametern simulieren kann, um Prozesssimulationsdaten für diese Kombination zu erhalten. Dadurch können beispielsweise für stark nicht-lineare Prozessparameter zusätzliche Prozessparameterwerte simuliert werden, um das Verhalten der Prozesssimulationsdaten bezüglich einer Variation des Prozessparameters genauer abzubilden.

In einigen Ausführungsbeispielen gemäß der Erfindung basiert der Linearitätsindikator auf einer Hessematrix, die ein Maß für die partielle Ableitung zweiter Ordnung der Prozesssimulationsdaten Funktionale unter Variation der Prozessparameter angibt.

Ausführungsbeispiele gemäß der Erfindung werden nachfolgend bezugnehmend auf die beiliegenden Figuren näher erläutert. Es zeigen:

Fig. 1    ein Blockdiagramm einer Vorrichtung zum Bearbeiten einer Prozesssimulationsdatenbasis eines Prozesses;

Fig. 2    ein Blockdiagramm einer Vorrichtung zum Bearbeiten einer Prozesssimulationsdatenbasis eines Prozesses;

Fig. 3    ein Blockdiagramm einer Vorrichtung zum Bearbeiten einer Prozesssimulationsdatenbasis eines Prozesses;

Fig. 4    eine schematische Darstellung einer Singulärwertzerlegung;

Fig. 5    eine schematische Darstellung einer Anpassung von Prozesssimulationsdaten;

Fig. 6    einen schematischen Ablauf des Verfahrens am Beispiel einer Prozesskette Umformen-Crash; und

Fig. 7    ein Flussdiagramm eines Verfahrens zum Bearbeiten einer Prozesssimulationsdatenbasis eines Prozesses.

Im Folgenden werden teilweise für Objekte und Funktionseinheiten, die gleiche oder ähnliche funktionelle Eigenschaften aufweisen, gleiche Bezugszeichen verwendet. Des Weiteren können optionale Merkmale der verschiedenen Ausführungsbeispiele miteinander kombinierbar oder zueinander austauschbar sein.

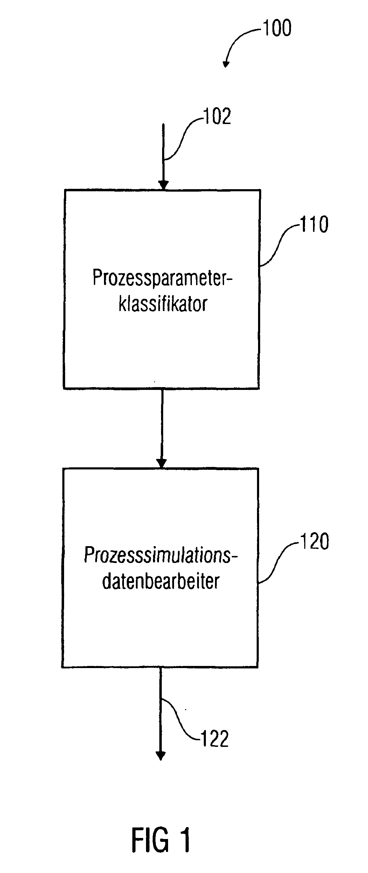

Fig. 1 zeigt ein Blockdiagramm einer Vorrichtung 100 zum Bearbeiten einer Prozesssimulationsdatenbasis 102 eines Prozesses entsprechend eines Ausführungsbeispiels gemäß der Erfindung. Die Prozesssimulationsdatenbasis 102 des Prozesses umfasst Prozesssimulationsdaten einer Mehrzahl von Prozesssimulationen des Prozesses, wobei jede Prozesssimulation der Mehrzahl von Prozesssimulationen auf einer unterschiedlichen Variation einer Mehrzahl von Prozessparametern basiert. Für jeden Prozessparameter der Mehrzahl von Prozessparametern sind für eine initiale Anzahl von unterschiedlichen Prozessparameterwerten Prozesssimulationsdaten einer Prozesssimulation in der Prozesssimulationsdatenbasis 102 enthalten. Die Vorrichtung 100 umfasst einen Prozessparameterklassifikator 110, der mit einem Prozesssimulationsdatenbearbeiter 120 verbunden ist. Der Prozessparameterklassifikator 110 berechnet für einen variierten Prozessparameter der Mehrzahl von Prozessparametern einen Linearitätsindikator. Die Berechnung des Linearitätsindikators basiert auf einer Analyse der Prozesssimulationsdatenbasis 102 bezüglich einer Linearität eines Einflusses einer Variation zumindest des variierten Prozessparameters auf die Prozesssimulationsdaten in der Prozesssimulationsdatenbasis 102. Des Weiteren verändert der Prozesssimulationsdatenbearbeiter 120 die initiale Anzahl von unterschiedlichen Prozessparameterwerten des variierten Prozessparameters, für welche Prozesssimulationsdaten einer Prozesssimulation in der Prozesssimulationsdatenbasis 102 enthalten sind, um eine bearbeitete Prozesssimulationsdatenbasis 122 zu erhalten. Die Veränderung der initialen Anzahl von unterschiedlichen Prozessparameterwerten erfolgt basierend auf dem berechneten Linearitätsindikator. In anderen Worten, durch die Veränderung der initialen Anzahl von unterschiedlichen Prozessparameterwerten, für die Prozesssimulationsdaten in der Prozesssimulationsdatenbasis 102 enthalten sind, können Prozesssimulationsdaten für weitere Prozessparameterwerte des variierten Prozessparameters der Prozesssimulationsdatenbasis 102 hinzugefügt werden oder Prozesssimulationsdaten von unterschiedlichen Prozessparameterwerten des variierten Prozessparameters aus der Prozesssimulationsdatenbasis 102 entfernt werden.

Durch das beschriebene Konzept kann die Datenmenge in der Prozesssimulationsdatenbasis 102 basierend auf dem berechneten Linearitätsindikator beeinflusst werden. Durch den berechneten Linearitätsindikator kann beispielsweise festgestellt werden, in welchem Ausmaß ein Prozessparameter unter Variation Einfluss auf die Prozesssimulationsdaten in der Prozesssimulationsdatenbasis 102 nimmt. Entsprechend können Prozessparameter klassifiziert und unterschiedlich behandelt werden. Dadurch kann einerseits die Datenmenge in der Prozesssimulationsdatenbasis 102 reduziert werden (z. B. für einflussarme Prozessparameter, Prozessparameter mit lineare oder schwach nicht-lineare Einfluss) oder die die Neuigkeit der Berücksichtigung der Prozessparameter (z. B. für Prozessparameter mit stark nicht-lineare Einfluss) erhöht werden. Durch die Reduktion der Datenmenge in der Prozesssimulationsdatenbasis 102 kann eine spätere Verwendung oder weitere Bearbeitung (z.B. durch Simulation von Folgeprozessen basierend auf der bearbeiteten Prozesssimulationsdatenbasis 122) der bearbeiteten Prozesssimulationsdatenbasis deutlich beschleunigt werden. Im Folgenden werden Prozessparameter mit keinem oder geringem Einfluss auf die Prozesssimulationsdaten auch einflussarme Prozessparameter, Prozessparameter mit linearem oder schwach nichtlinearem Einfluss auch lineare oder schwach nichtlineare Prozessparameter und Prozessparameter mit stark nichtlinearem Einfluss auch stark nichtlineare Prozessparameter genannt.

Die Prozesssimulationsdatenbasis 102 des Prozesses ist eine Ansammlung von Prozesssimulationsdaten zu unterschiedlichen Prozessparameterwerten von Prozessparameter, die für die Prozesssimulationen variiert werden. Dadurch kann beispielsweise das Verhalten des Prozesses unter Schwankung der Eingangsdaten, die unter anderem durch Prozessparameter bestimmt werden, untersucht werden. Dabei kann jeder Prozessparameter in einem individuell festgelegten Bereich variiert werden. Die initiale Anzahl von unterschiedlichen, aus dem jeweiligen Wertebereich gewählten Prozessparameterwerte eines variierten Prozessparameters kann für alle variierten Prozessparameter unterschiedlich sein, für einen Teil der variierten Prozessparameter gleich sein oder für alle variierten Prozessparameter gleich sein. Die Auswahl der unterschiedlichen Prozessparameterwerte kann beispielsweise durch einen Versuchsplan festgelegt werden. Auf diese Weise kann eine Prozesssimulationsdatenbasis 102 des Prozesses erzeugt werden, die von der erfindungsgemäßen Vorrichtung 100 zum Bearbeiten einer Prozesssimulationsdatenbasis 102 eines Prozesses bearbeitet werden kann.

Ein Prozessparameter kann je nach betrachtetem Prozess einer Vielzahl unterschiedlicher Größen darstellen. Prozessparameter ist in diesem Zusammenhang ein allgemeiner Begriff für Parameter, die auf einen Prozess Einfluss haben, wie z.B. Materialparameter (z.B. Elastizitätsmodul eines Materials), Prozessparameter (z.B. Prozesstemperatur), Geometrieparameter (z.B. Form des Ausgangsmaterials) oder externe Einflüsse (z.B. Luftfeuchtigkeit). In einem konkreten Beispiel kann es sich bei einem Prozessparameter in einem Umformprozess um einen Anpressdruck oder einen Reibungskoeffizienten einer Walze oder bei einem Schweißprozess um die Schweißtemperatur oder Schweißdauer handeln.

Das erfindungsgemäße Konzept ist grundsätzlich vom betrachteten Prozess unabhängig und kann daher für eine Vielzahl von Prozessen, wie z. B. Produktionsprozesse, Herstellungsprozesse, Bearbeitungsprozesse, Verarbeitungsprozesse, Umwandlungsprozesse oder Umformungsprozesse, um nur ein paar zu nennen, verwendet werden.

Die Prozesssimulation kann beispielsweise basierend auf Gittermodellen, die z. B. während eines Umformungsprozesses in ihrer Form verändert werden, erfolgen. Die Prozesssimulationsdaten als Ergebnis einer Prozesssimulation können dabei beispielsweise eine Blechdicke, eine Spannung oder eine Schädigungsdichte für jeden Gitterpunkt angeben. In diesem Zusammenhang können für einen Prozess auch mehrere Prozesssimulationsdatenbasen 102 erzeugt werden, die jeweils Prozesssimulationsdaten für ein Kriterium (Funktional) enthalten. Für das zuvor genannte Beispiel gebe es dann beispielsweise eine Prozesssimulationsdatenbasis für die Blechdicke, eine Prozesssimulationsdatenbasis für die Spannungen und eine weitere Prozesssimulationsdatenbasis für die Schädigungsdichte.

Die Prozesssimulationsdatenbasis 102 kann beispielsweise durch eine Matrix dargestellt werden, in der jede Spalte für eine Prozesssimulation zu einer konkreten Kombination von Prozessparameterwerten der Mehrzahl von Prozessparametern entsprechen und die Zeilen den Gitterpunkten des Simulationsgitters.

Der Prozessparameterklassifikator 110 berechnet für einen, mehrere oder alle variierten Prozessparameter der Mehrzahl von Prozessparametern einen Linearitätsindikator. Der Linearitätsindikator ist ein Maß für die Linearität eines Einflusses, den ein betrachteter Prozessparameter unter Variation auf die entsprechenden Prozesssimulationsdaten hat. Mit dieser Information kann der Prozesssimulationsdatenbearbeiter 120 beispielsweise die Menge an Daten in der Prozesssimulationsdatenbasis 102, die auf eine Variation des betrachteten Prozessparameters zurückzuführen sind, anpassen. Dies kann der Prozesssimulationsdatenbearbeiter 120 durch die Veränderung der initialen Anzahl von unterschiedlichen Prozessparameterwerten des betrachteten, variierten Prozessparameters, die durch Prozesssimulationsdaten in der Prozesssimulationsdatenbasis berücksichtigt sind, machen.

Der Linearitätsindikator gibt ein Maß für die Linearität einer Veränderung von Prozesssimulationsdaten unter Variation zumindest des betrachteten, variierten Prozessparameters an, wobei zumindest des variierten Prozessparameters bedeutet, dass der Linearitätsindikator ein Maß ausschließlich für den variierten Prozessparameter, für mehrere variierte Prozessparameter oder für alle variierten Prozessparameter der Mehrzahl von Prozessparametern angibt. Der Linearitätsindikator wird basierend auf einer Analyse der Prozesssimulationsdatenbasis 102 bezüglich einer Linearität eines Einflusses einer Variation zumindest des variierten Prozessparameters auf die Prozesssimulationsdaten in der Prozesssimulationsdatenbasis 102 berechnet. Ein Einfluss ist beispielsweise linear, wenn sich die Prozesssimulationsdaten (z. B. die Blechdicke) bei einer linearen Variation des variierten Prozessparameters oder mehrerer der variierten Prozessparameter linear verändert. Ein Linearitätsindikator kann auf zahlreiche Arten definiert werden, wie im Folgenden noch ausgeführt wird.

In einigen Ausführungsbeispielen gemäß der Erfindung ordnet der Prozessparameterklassifikator 110 den variierten Prozessparameter einer ersten linearitätsabhängigen Klasse von Prozessparametern zu, wenn ein berechneter Linearitätsindikator des variierten Prozessparameters ein vordefiniertes Nicht-Linearitätskriterium erfüllt. Alternativ ordnet der Prozessparameterklassifikator 110 den variierten Prozessparameter einer zweiten linearitätsabhängigen Klase von Prozessparametern zu, wenn der berechnete Linearitätsindikator des variierten Prozessparameters das vordefinierte Nicht-Linearitätskriterium nicht erfüllt. Dabei weist ein Prozessparameter, der der ersten linearitätsabhängigen Klasse zugeordnet ist, einen stärkeren nicht-linearen Einfluss auf die Prozesssimulationsdaten in der Prozesssimulationsdatenbasis 102 auf, als ein Prozessparameter der der zweiten linearitätsabhängigen Klasse zugeordnet ist. Auf diese Weise kann der Prozessparameterklassifikator 110 einen, mehrere oder alle Prozessparameter der Mehrzahl von Prozessparametern klassifizieren. Diese Klassifikation kann dann vom Prozesssimulationsdatenbearbeiter 120 berücksichtigt werden. Allgemein kann ein Prozessparameter auch einer von mehr als zwei unterschiedlichen linearitätsabhängigen Klassen zugeordnet werden. Dazu können dann entsprechend auch mehrere vordefinierte Nicht-Linearitätskriterien definiert werden.

Das vordefinierte Nicht-Linearitätskriterium kann auf unterschiedliche Arten definiert werden und in Abhängigkeit von der konkreten Definition des Linearitätsindikators abhängen. Durch die Vorgabe des vordefinierten Nicht-Linearitätskriteriums kann sowohl die Datenmenge in der Prozesssimulationsdatenbasis als auch die Genauigkeit der Berücksichtigung von Einflüssen der Prozessparameter festgelegt werden, da durch das vordefinierte Nicht-Linearitätskriterium festgelegt werden kann, ab welcher Grenze ein Prozessparameter z.B. als stark nicht-linear angesehen wird und durch den Prozesssimulationsdatenbearbeiter 120 anders behandelt wird als ein beispielsweise als linear oder schwach nicht-linear klassifizierter Prozessparameter. Das vordefinierte Nicht-Linearitätskriterium kann auch vordefinierte Linearitätskriterium bezeichnet werden, da es von der Definition des vordefinierte Nicht-Linearitätskriterium (z.B. durch eine Ungleichung) abhängt, ob ein Prozessparameter einen lineareren Einfluss auf die Prozesssimulationsdaten unter Variation hat, wenn der Prozessparameter das vordefinierte Nicht-Linearitätskriterium erfüllt oder nicht erfüllt. Ebenso kann der Linearitätsindikator je nach Definition auch Nicht-Linearitätsindikator bezeichnet werden.

Der Prozesssimulationsdatenbearbeiter 120 kann beispielsweise basierend auf der Klassifizierung der Prozessparameter die initiale Anzahl von unterschiedlichen Prozessparameterwerten eines betrachteten variierten Prozessparameters verändern, so dass eine veränderte Anzahl von unterschiedlichen Prozessparameterwerten des variierten Prozessparameters (für welche Prozesssimulationsdaten einer Prozesssimulation in der Prozesssimulationsdatenbasis 102 enthalten sind) kleiner ist, wenn der variierte Prozessparameter der zweiten linearitätsabhängigen Klasse von Prozessparametern zugeordnet ist, als eine veränderte Anzahl von unterschiedlichen Prozessparameterwerten des variierten Prozessparameters (für welche Prozesssimulationsdaten einer Prozesssimulation in der Prozesssimulationsdatenbasis 102 enthalten sind), wenn der variierte Prozessparameter der ersten linearitätsabhängigen Klasse von Prozessparametern zugeordnet ist. In anderen Worten, ein Prozessparameter, der einen z.B. stark nicht-linearen Einfluss auf die Prozesssimulationsdaten hat, kann mit einer größeren Anzahl von Prozesssimulationsdaten zu unterschiedlichen Prozessparameterwerten berücksichtigt werden als ein Prozessparameter, der keinen, einen linearen oder einen schwach nicht-linearen Einfluss auf die Prozesssimulationsdaten hat. Als Konsequenz kann beispielsweise bei einer Prozesssimulationsdatenbasis 102, die eine Variation von vielen Prozessparametern ohne Einfluss, mit linearem Einfluss oder schwach nicht-linearen Einfluss auf die Prozesssimulationsdaten beinhaltet, die Datenmenge deutlich reduziert werden, da für diese Prozessparameter nur wenige unterschiedliche Prozessparameterwerte berücksichtigt werden können, ohne viel an Genauigkeit zu verlieren. Umgekehrt kann bei einer Prozesssimulationsdatenbasis 102, die viele Prozessparameter mit stark nicht-linearen Einfluss auf die Prozesssimulationsdaten aufweist, die Genauigkeit der Abbildung des Einflusses auf die Prozesssimulationsdaten deutlich erhöht werden, indem beispielsweise zusätzliche unterschiedliche Prozessparameterwerte für die stark nicht-linearen Prozessparameter berücksichtigt werden.

Zusätzlich kann durch den Prozessparameterklassifikator 110 allgemein die Stärke eines Einflusses der Variation eines Prozessparameters auf die Prozesssimulationsdaten in der Prozesssimulationsdatenbasis 102 berücksichtigt werden. Dazu kann der Prozessparameterklassifikator 110 in einigen Ausführungsbeispielen gemäß der Erfindung einen Einflussstärkeindikator, basierend auf einer Analyse der Prozesssimulationsdatenbasis bezüglich einer Stärke eines Einflusses einer Variation des variierten Prozessparameters auf die Prozesssimulationsdaten in der Prozesssimulationsdatenbasis 102 berechnen. Danach kann der Prozessparameterklassifikator 110 den variierten Prozessparameter einer ersten einflussabhängigen Klasse von Prozessparametern zuordnen, wenn der Einflussstärkeindikator ein minimales Einflusskriterium erfüllt. Alternativ kann der Prozessparameterklassifikator 110 den variierten Prozessparameter einer zweiten einflussabhängigen Klasse von Prozessparametern zuordnen, wenn der Einflussstärkeparameter das minimale Einflusskriterium nicht erfüllt. Ein Prozessparameter, der der ersten einflussabhängigen Klasse zugeordnet ist, weist dabei einen stärkeren Einfluss auf die Prozesssimulationsdaten in der Prozesssimulationsdatenbasis 102 auf, als ein Prozessparameter der der zweiten einflussabhängigen Klasse von Prozessparametern zugeordnet ist. Die Klassifikation der Prozessparameter in einflussabhängige Klassen kann beispielsweise vom Prozesssimulationsdatenbearbeiter 120 verwendet werden, um Prozessparameter in unterschiedlichen Klassen unterschiedlich zu berücksichtigen. Allgemein kann ein Prozessparameter auch einer von mehr als zwei unterschiedlichen einflussabhängigen Klassen zugeordnet werden. Dazu können dann entsprechend auch mehrere minimale Einflusskriterien definiert werden.

Der Prozesssimulationsdatenbearbeiter 120 kann beispielsweise die initiale Anzahl von unterschiedlichen Prozessparameterwerten des variierten Prozessparameters verändern, so dass eine veränderte Anzahl von unterschiedlichen Prozessparameterwerten des variierten Prozessparameters (für welche Prozesssimulationsdaten einer Prozesssimulation in der Prozesssimulationsdatenbasis 102 enthalten sind) kleiner ist, wenn der variierte Prozessparameter der zweiten einflussabhängigen Klasse von Prozessparameter zugeordnet ist, als eine veränderte Anzahl von unterschiedlichen Prozessparameterwerten des variierten Prozessparameters (für welche Prozesssimulationsdaten einer Prozesssimulation in der Prozesssimulationsdatenbasis 102 enthalten sind), wenn der variierte Prozessparameter der ersten einflussabhängigen Klasse von Prozessparametern zugeordnet ist. In anderen Worten, ein Prozessparameter, der unter Variation einen kleinen Einfluss auf die Prozesssimulationsdaten hat, kann durch eine geringere Anzahl von Prozesssimulationsdaten zu unterschiedlichen Prozessparameterwerten berücksichtigt werden als ein Prozessparameter, der unter Variation einen stärkeren Einfluss auf die Prozesssimulationsdaten hat.

Der Einflussstärkeindikator kann auf unterschiedliche Arten definiert werden, wie noch im Folgenden gezeigt wird. Auch das minimale Einflusskriterium kann auf unterschiedliche Arten definiert werden. Wie für das vordefinierte Nicht-Linearitätskriterium beschrieben, kann auch durch ein Festlegen des minimalen Einflusskriteriums beeinflusst werden, wie stark die Menge an Daten in der Prozesssimulationsdatenbasis 102 und/oder die Genauigkeit der Prozesssimulationsdaten in der Prozesssimulationsdatenbasis 102 unter Variation der Prozessparameter beeinflusst wird.

Bei einigen Ausführungsbeispielen gemäß der Erfindung erfolgt eine Zuordnung eines variierten Prozessparameters sowohl in linearitätsabhängige Klassen als auch in einflussabhängige Klassen. In diesem Fall ordnet der Prozessparameterklassifikator 110 den variierten Prozessparameter beispielsweise zuerst der ersten linearitätsabhängigen Klasse von Prozessparametern oder der zweiten linearitätsabhängigen Klasse von Prozessparametern zu. Danach ordnet der Prozessparameterklassifikator 110 den variierten Prozessparameter der ersten einflussabhängigen Klasse von Prozessparametern oder der zweiten einflussabhängigen Klasse von Prozessparametern zu, wenn der variierte Prozessparameter zuvor der zweiten linearitätsabhängigen Klasse von Prozessparametern zugeordnet wurde. Dadurch müssen Prozessparameter, die der ersten linearitätsabhängigen Klasse zugeordnet wurden, nicht mehr einer einflussabhängigen Klasse zugeordnet werden, da ein Prozessparameter in der ersten linearitätsabhängigen Klasse z.B. einen stark nicht-linearen Einfluss auf die Prozesssimulationsdaten hat und von daher sowieso nicht in die zweite einflussabhängige Klasse von wenig bis gar nicht einflussreichen Prozessparametern eingeteilt werden kann.

Nach Einteilung eines Prozessparameters in linearitätsabhängige Klassen und/oder einflussabhängige Klassen kann der Prozesssimulationsdatenbearbeiter 120 die Prozesssimulationsdatenbasis 102 bearbeiten. Beispielsweise kann der Prozesssimulationsdatenbearbeiter 120 die initiale Anzahl von unterschiedlichen Prozessparameterwerten eines betrachteten, variierten Prozessparameters auf zwei unterschiedliche Prozessparameterwerte des variierten Prozessparameters reduzieren (falls für diesen Prozessparameter nicht bereits genau zwei unterschiedliche Prozessparameterwerte berücksichtigt sind), für die Prozesssimulationsdaten einer Prozesssimulation in Prozesssimulationsdatenbasis 102 enthalten sind, wenn der variierte Prozessparameter der zweiten linearitätsabhängigen Klasse von Prozessparametern und der ersten einflussabhängigen Klasse von Prozessparametern zugeordnet ist. Andererseits kann der Prozesssimulationsdatenbearbeiter 120 die initiale Anzahl von unterschiedlichen Prozessparameterwerten des variierten Prozessparameters auf einen einzigen Prozessparameterwert des variierten Prozessparameters reduzieren, für den Prozesssimulationsdaten einer Prozesssimulation in der Prozesssimulationsdatenbasis 102 enthalten sind, wenn der variierte Prozessparameter der zweiten linearitätsabhängigen Klasse und der zweiten einflussabhängigen Klasse zugeordnet ist. In diesem Fall ist der Prozessparameter dann nicht mehr Teil der Mehrzahl von variierten Prozessparametern, da in der Prozesssimulationsdatenbasis 102 nur noch Prozesssimulationsdaten für einen Prozessparameterwert des Prozessparameters enthalten sind und daher keine Variationen des Prozessparameters mehr erfolgt.

In anderen Worten, für einen Prozessparameter, der ohnehin keinen oder einen vernachlässigbaren Einfluss auf die Prozesssimulationsdaten unter Variation hat, kann es ausreichend sein, Prozesssimulationsdaten für einen einzigen Prozessparameterwert zu berücksichtigen. Hingegen kann es für einen Prozessparameter, der mehr als einen minimalen Einfluss (definiert durch das minimale Einflusskriterium) jedoch keinen stark nicht-linearen (definiert durch das vordefiniert Nicht-Linearitätskriterium) Einfluss auf die Prozesssimulationsdaten unter Variation hat, ausreichend sein, das lineare oder schwach nicht-lineare Verhalten durch die Berücksichtigung von Prozesssimulationsdaten zu zwei unterschiedlichen Prozessparameterwerten des betrachteten Prozessparameters zu berücksichtigen.

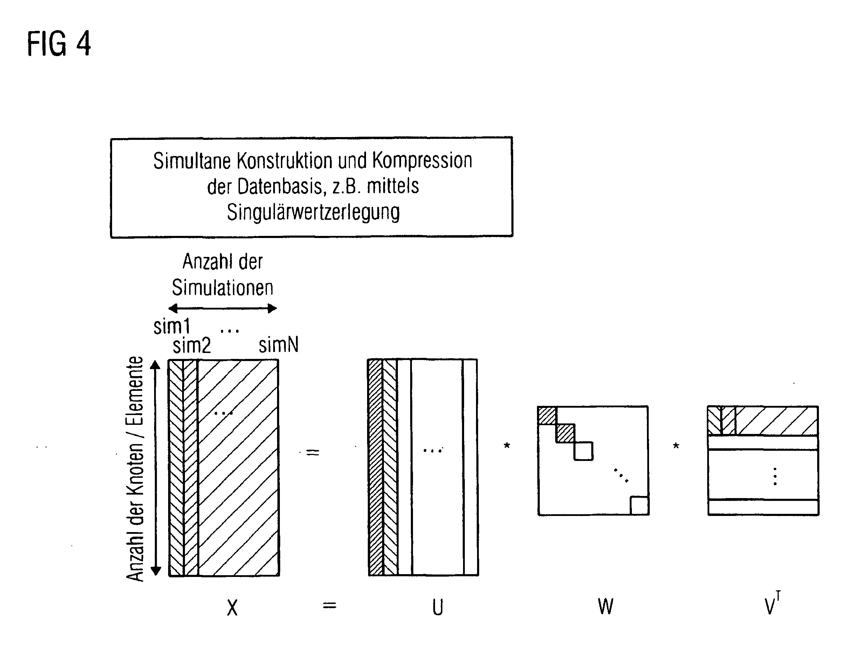

Wie bereits erwähnt, kann der Linearitätsindikator auf viele verschiedene Weisen definiert und berechnet werden. Die Berechnung kann beispielsweise auf einer Basistransformation einer Prozesssimulationsdatenmatrix berechnet werden, wobei die Prozesssimulationsdatenmatrix die Prozesssimulationsdatenbasis 102 repräsentiert. Unter anderem kann die Berechnung des Linearitätsindikators, beispielsweise basierend auf einer Singulärwertzerlegung der Prozesssimulationsdatenmatrix oder einem kembasierten Verfahren erfolgen. Ein schematisches Beispiel für eine Singulärwertzerlegung einer Prozesssimulationsdatenmatrix ist in Fig. 4 gezeigt. Dabei stellt die Matrix X die Prozesssimulationsdatenmatrix dar, die die Prozesssimulationsdatenbasis repräsentiert. In einer Spalte der Prozesssimulationsdatenmatrix X sind die Prozesssimulationsdaten (z. B. Blechdicken, Spannungen oder Schädigungsdichten) einer Prozesssimulationen zu einer Kombinationen von Prozessparameterwerten der Mehrzahl von Prozessparametern enthalten. In einer Zeile der Prozesssimulationsdatenmatrix X sind demnach die Prozesssimulationsdaten von unterschiedlichen Prozesssimulationen für unterschiedliche Kombinationen von Prozessparameterwerten für ein Prozesssimulationsdatenelement (z. B. die Blechdicke in einem Punkt eines Simulationsgitters) enthalten. Diese Prozesssimulationsdatenmatrix X kann durch die Singulärwertzerlegung z.B. in drei Matrizen U, W, V zerlegt werden.

$$X = U \ W \ V^T$$

Die Matrix U enthält in ihren Zeilen, wie die Matrix X, die unterschiedlichen Prozesssimulationsdatenelemente und die erste Spalte repräsentiert einen Mittelwert dieser über die Prozesssimulationen. In der zweiten Spalte ist eine Abweichung erster Ordnung von diesem Mittelwert enthalten, in der dritten Spalte eine Abweichung zweiter Ordnung usw. Die Matrix U hat dieselbe Anzahl von Zeilen wie die Matrix X, die der Anzahl der Prozesssimulationsdatenelementen (z.B. Anzahl der Gitterpunkte eines Simulationsgitters) der Prozesssimulationsdatenbasis entspricht. Ebenso hat die Matrix U eine Anzahl von Spalten, die der Anzahl von Spalten der Matrix X entspricht, die gleich der Anzahl von Prozesssimulationen der Mehrzahl von Prozesssimulationen ist. Die Matrix W ist eine Diagonalmatrix und hat in ihrer Diagonale in absteigender Reihenfolge Gewichtungsfaktoren stehen. Die Matrix W hat eine Anzahl von Zeilen und Spalten, die der Anzahl der Prozesssimulationen entspricht. Die Matrix $V^T$ hat in einer Spalte Gewichtungsfaktoren für den Mittelwert und seine Abweichungen der Matrix U stehen und in jeder Zeile ist ein Gewichtungsfaktor für die unterschiedlichen Prozesssimulationen enthalten. Die Prozesssimulationsdatenelemente können auch z.B. Knoten oder allgemein Elemente genannt werden.

In einigen Ausführungsbeispielen gemäß der Erfindung kann der Linearitätsindikator eines betrachteten variierenden Prozessparameters basierend auf einer Hessematrix berechnet werden. Die Hessematrix gibt dabei ein Maß für die partielle Ableitung zweiter Ordnung der Prozesssimulationsdaten unter Variation der Mehrzahl von Prozessparametern an. Dabei kann die Hessematrix beispielsweise basierend auf einer unitären Matrix (z. B. Matrix V) der Singulärwertzerlegung der Prozesssimulationsdatenmatrix X berechnet werden.

In diesem Beispiel ist es auch möglich, die unitäre Matrix durch eine Vernachlässigung von Zeilen zu reduzieren. Die Reduktion kann dabei bestimmt werden durch ein Vernachlässigen von Diagonalelementen der Diagonalmatrix W der Singularwertzerlegung. Die diagonalen Elemente der Diagonalmatrix W sind in absteigender Reihenfolge sortiert. Dementsprechend haben die Diagonalelemente immer weniger Einfluss auf das Gesamtergebnis. Somit können in Abhängigkeit eines Genauigkeitskriteriums Diagonalelemente entfernt oder auf Null gesetzt werden, wodurch entsprechend Zeilen der unitären Matrix $V^T$ und Spalten der Matrix U nicht mehr berücksichtigt werden.

Zusätzlich kann der Prozessparameterklassifikator 110 eine Jacobimatrix berechnen, die ein Maß für die erste Ableitung der Prozesssimulationsdaten unter Variation der Mehrzahl von Prozessparametern angibt. Danach kann der Prozesssimulationsdatenbearbeiter 120 einen betrachteten variierten Prozessparameter, basierend auf einem Vergleich eines auf der Jacobimatrix basierenden Vergleichsparameters mit dem auf der Hessematrix basierenden Linearitätsindikator der ersten linearitätsabhängigen Klasse von Prozessparametern oder der zweiten linearitätsabhängigen Klasse von Parametern zuordnen. Mit anderen Worten, durch Vergleich eines Maßes für eine Schwankung erster Ordnung der Prozesssimulationsdaten mit einem Maß für die Schwankung zweiter Ordnung der Prozesssimulationsdaten kann ein betrachteter variierter Prozessparameter klassifiziert werden.

Beispielsweise kann der Linearitätsindikator, basierend auf einem maximalen Eigenwert der Hessematrix berechnet werden und mit einem auf der Jacobimatrix basierenden Vergleichsparameter verglichen werden, wodurch gleichzeitig erkannt werden kann, ob alle Prozessparameter der Mehrzahl der Prozessparametern ein vordefiniertes Nicht-Linearitätskriterium nicht erfüllen (oder erfüllen, je nach Definition des Linearitätsindikators und des Nicht-Linearitätskriterium). Demzufolge können dann alle Prozessparameter der Mehrzahl von Prozessparametern zur zweiten linearitätsabhängigen Klasse von Prozessparametern zugeordnet werden. In anderen Worten, der maximale Eigenwert der Hessematrix gibt ein Maß für das lineare oder nicht-lineare Verhalten aller variierter Prozessparameter wieder, wodurch durch einen Vergleich mit dem Jacobimatrix basierten Vergleichsparameter alle Prozessparameter auf einmal klassifiziert werden können, wenn das Nicht-Linearitätskriterium nicht erfüllt ist. Ist das Nicht-Linearitätskriterium erfüllt, so hat zumindest einer der Prozessparameter der Mehrzahl von Prozessparametern einen stark nicht linearen Einfluss auf die Prozesssimulationsdaten unter Variation in Bezug auf das vordefinierte Nicht-Linearitätskriterium. Somit kann, unter Umständen, bereits an dieser Stelle eine Klassifizierung aller Prozessparameter erfolgen, ohne jeden Prozessparameter individuell zu betrachten. Der Linearitätsindikator kann dabei z.B. der Eigenwert selbst, ein gewichteter Eigenwert oder ein in anderer Weise deterministisch vom Eigenwert abhängender Wert sein. Dies gilt auch in weiterer Folge allgemein, wenn ein Linearitätsindikator auf einem Eigenwert basiert.

Um den zumindest einen nicht-linearen Prozessparameter aus der Teilmenge zu extrahieren, kann beispielsweise eine Basistransformation in einen Basisraum durchgeführt werden, der Eigenvektoren aufweist, die nur jeweils von einem der Prozessparameter der Teilmenge von Prozessparametern abhängen. Dort können dann die Eigenvektoren mit zugehörigen Eigenwerten berechnet werden und die Eigenwerte wiederum zur Berechnung von Linearitätsindikatoren verwendet werden. Die Linearitätsindikatoren können dann jeweils mit einem auf der Jacobimatrix basierenden Vergleichsparameter verglichen werden. Dadurch kann ein oder mehrere Eigenwerte bestimmt werden, für den ein Nicht-Linearitätskriterium erfüllt ist und die zugehörigen Prozessparameter können der ersten linearitätsabhängigen Klasse zugeordnet werden. In anderen Worten, der Prozessparameterklassifikator 110 kann für jeden Prozessparameter der Teilmenge von variierten Prozessparametern einen Eigenvektor mit zugehörigen Eigenwert berechnen, so dass jeder Eigenvektor nur von jeweils einem Prozessparameter der Teilmenge von variierten Prozessparametern abhängt und von den anderen Prozessparametern der Teilmenge von Prozessparametern unabhängig ist. Des Weiteren berechnet der Prozessparameterklassifikator 110 für jeden Eigenwert der Eigenvektoren einen Linearitätsindikator, basierend auf dem jeweiligen Eigenwert und vergleicht diese mit einem auf der Jacobimatrix basierenden Vergleichsparameter, um einen Eigenwert zu bestimmen, für den ein Nicht-Linearitätskriterium erfüllt ist und um den zugehörigen Prozessparameter der ersten linearitätsabhängigen Klasse von Prozessparametern zuzuordnen.

Alternativ können auch beispielsweise für die Hessematrizen nur die Diagonalelemente berechnet werden und basierend auf den Diagonalelementen direkt Linearitätsindikatoren für die jeweiligen Prozessparameter berechnet werden, um eine individuelle Klassifikation der Prozessparameter der Mehrzahl von Prozessparametern zu ermöglichen.

Im Folgenden werden konkrete Beispiele für Linearitätsindikatoren und ein Nicht-Linearitätskriterium gezeigt, die basierend auf einer Singulärwertzerlegung einer Prozesssimulationsdatenmatrix, einer Hessematrix und einer Jacobimatrix erfolgen.

Konkreter werden zum Beispiel Approximationen für die Jacobimatrix J und die Hessematrix H berechnet,

$$J_{ik} = \partial x_i\,/\,\partial par_k \qquad H_{jk}^{(i)} = \partial^2 x_i\,/(\partial par_j \partial par_k).$$

Hier kann z.B. direkt das Ergebnis der Basistransformation verwendet werden, im Falle der Singulärwertzerlegung werden die Koeffizienten in V betrachtet. Dabei steht der Index i für eine Zeile der Matrix V und die Indizes j und k für einen Prozessparameter der Mehrzahl von variierten Prozessparametern.

Als Schätzer für den Grad der Nichtlinearität kann folgendes Maß verwendet werden, falls die Hessematrix Null oder annähernd Null ist, kann das Verhalten als linear bzw. schwach nichtlinear angesehen werden. Falls z.B. gilt

$$J^{(i)} < \frac{D}{4} H_{\max}^{(i)},$$

sollte das Verhalten als nichtlinear angesehen werden. Die angegebene Ungleichung ist ein Beispiel für ein vordefiniertes Nicht-Linearitätskriterium. Das vordefinierte Nicht-Linearitätskriterium kann für jede Zeile i überprüft werden. Es kann jedoch ausreichend sein, das vordefinierte Nicht-Linearitätskriterium für nur eine Zeile zu überprüfen (z.B. bevorzugt für die Zeile mit dem größten Einfluss in der Singulärwertzerlegung). Hierbei ist $J^{(i)} = \sqrt{\sum_j J_{ij}^2}$, , D der Durchmesser der Region, in der die Prozessparameter variiert wurden (z.B. repräsentiert durch die Größe des Wertebereichs in dem der Prozessparameter mit dem größten Wertebereich variiert oder einem Mittelwert der Wertebereiche aller Prozessparameter der Mehrzahl von Prozessparametern), und $H_{\max}^{(i)}$ der maximale absolute Eigenwert von $H_{jk}^{(i)}$. . $J^{(i)}$ repräsentiert dann den von der Jacobimatrix abhängigen Vergleichsparameter und D/4 $H^{(i)}{}_{max}$ den Linearitätsindikator. Über eine Sensitivitätsanalyse (Berechnung eines Einflussstärkeindikators) können zudem diejenigen Parameter bestimmt werden, deren Schwankungen keine für den Benutzer relevanten Auswirkungen zeigen und daher nicht weiter untersucht werden müssen.

Die Abhängigkeit von den Parametern steht implizit in den Formeln.

In anderen Worten, wenn man nur einen Parameter hat, berechnet man $J_{i1}$ und $H^{(i)}{}_{11}$.

Wenn man mehrere Parameter hat und nur einen betrachten will, gibt $J_{i1}$ die erste Ableitung bzgl. dieses Parameters und $H^{(i)}_{11}$ die 2te Ableitung bzgl. dieses Parameters und $H^{(i)}_{j1}$ die 2te Ableitung bzgl. dieses und einigen anderen Parametern.

Falls gilt, dass $J^{(i)} < \dfrac{D}{4} H^{(i)}_{\max}$ ist das Verhalten nichtlinear.

Dieses Kriterium betrachtet die Eigenwerte der gesamten Hessematrix, also unabhängig von einem bestimmten Parameter.

Falls nur ein Parameter existiert, ist $H^{(i)}\_$max gleich $|\,H^{(i)}_{11}\,|$. Wenn mehrere Parameter existieren, dann betrachtet man alle Elemente von $H^{(i)}_{jk}$, wobei jk zu den Parametern gehört und i die Zeile ist (also das Kriterium. Zur Erinnerung: Zeile von V korrespondiert zu Spalte von U, dies ist Mittelwert und Abweichungen davon).

Man vergleicht mit diesem Kriterium (vordefiniertes Nicht-Linearitätskriterium) bei einem Parameter also den maximalen absoluten Wert des linearen Teils der Ableitung mit dem maximalen absoluten Wert des quadratischen Teils, wenn alle Parameter in einer Sphäre mit dem Durchmesser D variiert wurden.

Wenn man z.B. einen Parameter betrachtet, kann also eintragsweise pro Parameter verglichen werden, bei mehreren kann das gesamte Verhalten beurteilt werden und dies pro Kriterium.

In nochmals anderen Worten, als Schätzer für den Grad der Nichtlinearität kann folgendes Maß verwendet werden, falls die Hessematrix Null oder annähernd Null ist, ist das Verhalten als linear bzw. schwach nichtlinear anzusehen.

Falls gilt, dass $J^{(i)} > \dfrac{D}{4} H^{(i)}_{\max}$, kann das Verhalten aller Parameter als linear angesehen werden.

Falls gilt, dass $J^{(i)} < \dfrac{D}{4} H^{(i)}_{\max}$, S, sollte das Verhalten insgesamt als nichtlinear angesehen werden, d.h. es gibt Parameter die sich nichtlinear auswirken.

Nun wird bestimmt welche Parameter(-kombinationen) sich nichtlinear auswirken.

Hierzu können z.B. alle Eigenwerte $\lambda_1$ der Hessematrix $H^{(i)}$ berechnet werden.

Wenn gilt, dass $J^{(i)} < \dfrac{D}{4} \lambda_l$ (entspricht einem Beispiel für ein vordefiniertes Nicht-Linearitätskriterium), dann wirkt sich die, zu $\lambda_1$ gehörende, Linearkombination der Parameter, die durch den zugehörigen Eigenvektor bestimmt ist, nichtlinear aus. Alle Parameter die in dieser Kombination vorkommen, können bereits als nichtlinear behandelt werden. Um die Parameter weiter zu unterscheiden, kann auch ein Eigenvektor gewählt werden, der nur zu einem Parameter korrespondiert und alle anderen Parameter auf Null setzt. Erfüllt nun der zugehörige Eigenwert $\lambda_1$, die Ungleichung $J^{(i)} < \dfrac{D}{4} \lambda_l$, so zeigt dieser Parameter nichtlinearen Einfluss. $J^{(i)}$ repräsentiert dann den von der Jacobimatrix abhängigen Vergleichsparameter und $D/4\ \lambda_1$ den Linearitätsindikator.

Über eine Sensitivitätsanalyse, z. B. basierend auf einem relativen Vergleich der Spalten der Jacobimatrix untereinander, können zudem diejenigen Parameter bestimmt werden, deren Schwankungen keine für den Benutzer relevanten Auswirkungen zeigen und daher nicht weiter untersucht werden müssen.

Das beschriebene Beispiel ermöglicht beispielsweise eine simultane Konstruktion und Kompression der Datenbasis, z.B. mittels Singulärwertzerlegung.

In einigen Ausführungsbeispielen gemäß der Erfindung wird eine Jacobimatrix berechnet, um eine Klassifikation von Prozessparametern bezüglich der Stärke ihres Einflusses auf die Prozesssimulationsdaten unter Variation der Prozessparameter zu ermöglichen. Dazu berechnet beispielsweise der Prozessparameterklassifikator 110 eine Jacobimatrix, die ein Maß für die erste Ableitung der Prozesssimulationsdaten unter Variation der Mehrzahl von Prozessparametern angibt. Des Weiteren ordnet der Prozessparameterklassifikator 110 einen betrachteten, variierten Prozessparameter basierend auf einem Vergleich des Einflussstärkeindikators mit einem auf einer Spalte der Jacobimatrix basierenden Vergleichsparameter der ersten einflussabhängigen Klasse von Prozessparametern oder der zweiten einflussabhängigen Klasse von Prozessparametern zu. Den Einflussstärkeindikator berechnet der Prozessparameterklassifikator 110 basierend auf einer Spalte der Jacobimatrix, die ein Maß für die erste Ableitung von Prozesssimulationsdaten unter Variation des variierten Prozessparameters angibt. In anderen Worten, da die Spalten der Jacobimatrix ein Maß für die Schwankung der Prozesssimulationsdaten unter Variation des jeweiligen Prozessparameters angeben, kann durch einen Vergleich der Spalten untereinander festgestellt werden, welche Parameter sich im Vergleich zu anderen Parametern stark auswirken und welche wenig oder gar nicht.

Beispielsweise kann der Einflussstärkeindikator eines variierten Prozessparameters k ein Element der zugehörigen Spalte k der Jacobimatrix, ein Mittelwert über die Elemente der zugehörigen Spalte k der Jacobimatrix oder eine Summe der Elemente der zugehörigen Spalte k der Jacobimatrix sein. Der Einflussstärkeindikator kann dann mit einem äquivalenten Wert einer anderen Spalte m, die zu einem anderen Prozessparameter gehört, verglichen werden. Ist der Einflussstärkeindikator des variierten Prozessparameters k beispielsweise kleiner als die Hälfte, ein Fünftel, ein Zehntel oder noch weniger als der entsprechende Wert eines anderen Prozessparameters m (was einem Beispiel für ein minimales Einflusskriterium entspricht), so kann der betrachtete Prozessparameter als Prozessparameter mit keinem oder vernachlässigbarem Einfluss auf die Prozesssimulationsdaten (im betrachteten Variationsbereich des Prozessparameters) betrachtet werden, was gleich bedeutend mit einer Zuordnung in die zweite einflussabhängige Klasse ist. Beispiele für minimale Einflusskriterien sind:

$$J_{ik} < \frac{1}{10} J_{im} \quad \text{oder} \quad \sum_i J_{ik} < \frac{1}{10} \sum_i J_{im}$$

Umgekehrt ist der Einflussstärkeindikator eines Prozessparameters k doppelt, fünfmal, zehnmal oder noch größer als der entsprechende Wert eines anderen Prozessparameters m, so kann dieser als ein einflussreiche angesehen werden, was einer Zuordnung zu der ersten einflussabhängigen Klasse entspricht.

Allgemein gilt für die bereits gemachten Ausführungen und auch für die noch folgenden Ausführungen, dass dasselbe Ergebnis erzielt werden kann, wenn teilweise oder bei allen Matrizen (z.B. X, U, W, V$^\mathrm{T}$, J, H) Zeilen und Spalten vertauscht werden.

Eine Klassifikation der Prozessparameter kann für jeden Prozessparameter der Mehrzahl von variierten Prozessparametern erfolgen. Dafür kann der Prozessparameterklassifikator 110 für jeden Prozessparameter der Mehrzahl von Prozessparametern einen Linearitätsindikator und/oder einen Einflussstärkeindikator berechen.

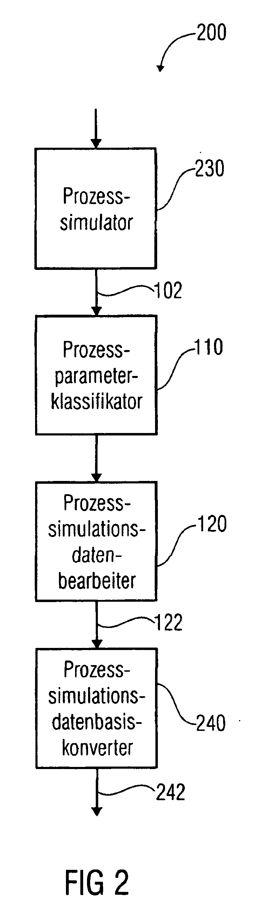

Fig. 2 zeigt ein Blockschaltbild einer Vorrichtung zum Bearbeiten einer Prozesssimulationsdatenbasis eines Prozesses entsprechend einem Ausführungsbeispiel gemäß der Erfindung. Die Vorrichtung 200 ist ähnlich der in Fig. 1 gezeigten Vorrichtung, umfasst jedoch zusätzlich einen Prozesssimulator 230 und/oder einen Prozesssimulationsdatenbasiskonverter 240. Der Prozesssimulator 230 und der Prozesssimulationsdatenbasiskonverter 240 sind optionale Einheiten, von denen beide einzeln oder beide gemeinsam implementiert sein können. Der optionale Prozesssimulator 230 ist mit dem Prozessparameterklassifikator 110 verbunden und der Prozesssimulationsdatenbearbeiter 120 ist mit dem optionalen Prozesssimulationsdatenbasiskonverter 240 verbunden.

Der Prozesssimulator 230 kann beispielsweise dazu verwendet werden, die Prozesssimulationsdaten der Prozesssimulationsdatenbasis 102 für die unterschiedlichen Variationen der Mehrzahl von Prozessparametern zu erzeugen. Die Mehrzahl von Prozessparametern kann dabei beispielsweise basierend auf einem Versuchsplan variiert werden. In anderen Worten, der Prozesssimulator 230 kann dazu verwendet werden, bereits die initiale Prozesssimulationsdatenbasis des Prozesses zu erstellen. Unabhängig davon kann der Prozesssimulator 230 auch nur oder zusätzlich für die Erzeugung von weiteren Prozesssimulationsdaten verwendet werden.

Der Prozesssimulator 230 kann den Prozess für eine Kombination von Prozessparameterwerten der Mehrzahl von Prozessparametern simulieren, um Prozesssimulationsdaten für die Kombination von Prozessparameterwerten zu erhalten und der Prozesssimulationsdatenbasis 102 hinzuzufügen. Dadurch kann die Prozesssimulationsdatenbasis erweitert werden, um beispielsweise die Genauigkeit der Darstellung des Verhaltens der Prozesssimulationsdaten unter Variation der Prozessparameter zu verbessern.

Beispielsweise kann der Prozesssimulationsdatenbearbeiter 120 zwei unterschiedliche Prozessparameterwerte für einen betrachteten, variierten Prozessparameter bestimmen. Für die beiden bestimmten Prozessparameterwerte des betrachteten variierten Prozessparameters kann der Prozesssimulator 230 in Kombination mit einer Variation der restlichen Prozessparameter der Mehrzahl von Prozessparametern neue Prozesssimulationsdaten erzeugen und die alten Prozesssimulationsdaten in der Prozesssimulationsdatenbasis 102 durch die neuen Prozesssimulationsdaten ersetzen, wenn der betrachtete variierte Prozessparameter der zweiten linearitätsabhängigen Klasse von Prozessparametern und der ersten einflussabhängigen Klasse von Prozessparametern zugeordnet ist. In anderen Worten, ist ein Prozessparameter als einflussreich mit linearem oder leicht nichtlinearem Einfluss auf die Prozesssimulationsdaten klassifiziert, so kann es ausreichend sein, für diesen Prozessparameter zwei unterschiedliche Prozessparameterwerte zu berücksichtigen, für die Prozesssimulationsdaten in der Prozesssimulationsdatenbasis 102 enthalten sind.

Andererseits kann der Prozesssimulationsdatenbearbeiter 120 zumindest drei Prozessparameterwerte für den betrachteten variierten Prozessparameter bestimmen, wenn der Prozessparameter der ersten linearitätsabhängigen Klasse zugeordnet ist. In anderen Worten, für einen Prozessparameter, der einen stark nichtlinearen Einfluss auf die Prozesssimulationsdaten hat, können mehr als zwei unterschiedliche Prozessparameterwerte, für die Prozesssimulationsdaten in der Prozesssimulationsdatenbasis enthalten sind, berücksichtigt werden, um das Verhalten mit ausreichender Genauigkeit darzustellen. Umso mehr unterschiedliche Prozessparameterwerte für den betrachteten variierten Prozessparameter berücksichtigt werden, umso genauer spiegeln die Prozesssimulationsdaten das Verhalten bezüglich einer Variation dieses Prozessparameters wieder. Der Prozesssimulationsdatenbearbeiter 120 kann Prozessparameterwerte bestimmen, die bereits in der initialen Anzahl von Prozessparameterwerten des betrachteten, variierten Prozessparameters enthalten sind, oder kann z.B. basierend auf einer Interpolation oder Approximation neu Prozessparameterwerte für den variierten Prozessparameter bestimmen.

Ist zumindest ein bestimmter Prozessparameterwert des betrachteten variierten Prozessparameters nicht bereits von der initialen Anzahl von Prozessparameterwerten des variierten Prozessparameters enthalten, so kann der Prozesssimulator 230 für alle vom Prozesssimulationsdatenbearbeiter 120 bestimmten Prozessparameterwerte, die nicht in der initialen Anzahl von Prozessparameterwerten des variierten Prozessparameters enthalten sind, in Kombination mit einer Variation der restlichen Prozessparameter der Mehrzahl von variierten Prozessparametern neue Prozesssimulationsdaten erzeugen und der Prozesssimulationsdatenbasis 102 hinzufügen. Optional kann der Prozesssimulationsdatenbearbeiter 120 Prozesssimulationsdaten von Prozessparameterwerten, die nicht vom Prozesssimulationsdatenbearbeiter 120 bestimmt wurden, aus der Prozesssimulationsdatenbasis entfernen. Dadurch kann eine möglichst genaue Wiedergabe des Verhaltens der Prozesssimulationsdaten unter Variation des nichtlinearen Prozessparameter mit möglichst wenig Prozesssimulationsdaten von Prozessparameterwerten des betrachteten nichtlinearen Prozessparameters durch die Prozesssimulationsdatenbasis erreicht werden.

Der Prozesssimulationsdatenbearbeiter 120 kann die Ergebnisse (Funktionale, Daten) für einen (neuen) betrachteten variierten Prozessparameterwert oder eine (neue) Mehrzahl von Prozessparameterwerten interpolieren bzw. approximieren, beispielsweise basierend auf einem Metamodellierungsverfahren, einem Antwort-Flächen-Modell-Verfahren, einem (nichtlinearen) Regressionsverfahren, radialen Basisfunktionen, einem Kriging-Verfahren, einem Wavelet-Verfahren, selbstorganisierenden Karten, Stützvektormaschinen oder neuronalen Netzen.

Der Prozesssimulationsdatenbearbeiter 120 kann zudem zusätzliche Funktionale, dies sind z.B. abgeleitete Funktionale aus den ursprünglichen Funktionalen, wie statistische Größen, z.B. Varianz, für einen (neuen) betrachteten variierten Prozessparameterwert oder eine (neue) Mehrzahl von Prozessparameterwerten interpolieren bzw. approximieren (durch die oben genannten Verfahren).

Der optionale Prozesssimulationsdatenbasiskonverter 240 kann beispielsweise die bearbeitete Prozesssimulationsdatenbasis 122 auf ein Simulationsgitter für eine Prozesssimulation eines Folgeprozesses übertragen, um eine konvertierte Prozesssimulationsdatenbasis 242 für den Folgeprozess zu erhalten, wobei das Simulationsgitter von dem Folgeprozess abhängt. In vielen Fällen unterscheiden sich Simulationsgitter auf denen Prozesssimulationen für einzelne Prozesse basieren. Um die in der bearbeiteten Prozesssimulationsdatenbasis 122 berücksichtigten Schwankungen der Mehrzahl von Prozessparametern für die Prozesssimulation eines Folgeprozesses nutzbar zu machen, kann diese überarbeitete Prozesssimulationsdatenbasis 122 auf ein Simulationsgitter des Folgeprozesses übertragen werden. Dadurch können Schwankungen von Prozessparametern über ganze Prozessketten verfolge werden. Beispielsweise können Prozesssimulationsdaten die bei der Herstellung eines Autos für die einzelnen Teile des Autos erhalten wurden, auf ein Simulationsgitter für einen Crashtest (Unfalltest) übertragen werden. Das Simulationsgitter des Crashtests hat dabei normalerweise deutlich weniger Gitterpunkte pro Bauteil als bei der Bauteilherstellungssimulation für jedes Bauteil verwendet werden. Dieses Problem kann durch die beschriebene Abbildung gelöst werden.

Der Prozesssimulationsdatenbasiskonverter (240) kann z.B. einen Qualitätsparameter berechnen. Der Qualitätsparameter ist ein Maß für einen Fehler der Übertragung der bearbeiteten Prozesssimulationsdatenbasis auf das Simulationsgitter der Prozesssimulation des Folgeprozesses. Zusätzlich kann der Prozesssimulationsdatenbasiskonverter (240) die bearbeitete Prozesssimulationsdatenbasis (122) übertragen, so dass der Qualitätsparameter kleiner ist als eine maximale Schwankung von Prozesssimulationsdaten in der Prozesssimulationsdaten in der bearbeiteten Prozesssimulationsdatenbasis (122) unter Variation der Mehrzahl von Prozessparametern.

Die in Fig. 2 gezeigte Vorrichtung 200 zum Bearbeiten einer Prozesssimulationsdatenbasis eines Prozesses kann auch beispielsweise als Vorrichtung zum Erzeugen einer Prozesssimulationsdatenbasis für eine Prozesssimulation eines Folgeprozesses, wobei der Folgeprozess einem Prozess folgt, für den Prozesssimulationen für eine unterschiedliche Variation einer Mehrzahl von Prozessparametern des Prozesses berücksichtigt werden. Die Vorrichtung umfasst einen Prozesssimulator 230 einer Vorrichtung zum Bearbeiten einer Prozesssimulationsdatenbasis 102 eines Prozesses, wie sie beispielsweise in Fig. 1 gezeigt ist, und einen Prozesssimulationsdatenbasiskonverter 240. Der Prozesssimulator 230 erzeugt Prozesssimulationsdaten für die unterschiedlichen Variationen der Mehrzahl von Prozessparametern des Prozesses, um eine Prozesssimulationsdatenbasis 102 des Prozesses zu erhalten. Die von dem Prozesssimulator 230 erzeugte Prozesssimulationsdatenbasis 102 des Prozesses wird dann von der Vorrichtung zum Bearbeiten einer Prozesssimulationsdatenbasis eines Prozesses bearbeitet. Der Prozesssimulationsdatenbasiskonverter 240 überträgt dann die bearbeitete Prozesssimulationsdatenbasis 122 auf ein Simulationsgitter für die Prozesssimulation des Folgeprozesses, um die Prozesssimulationsdatenbasis 242 für die Prozesssimulation des Folgeprozesses zu erzeugen, wobei das Simulationsgitter von dem Folgeprozess abhängt.

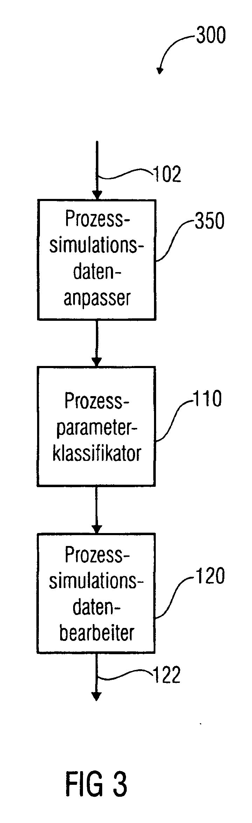

Fig. 3 zeigt ein Blockdiagramm einer Vorrichtung 300 zum Bearbeiten einer Prozesssimulationsdatenbasis eines Prozesses entsprechend einem Ausführungsbeispiel gemäß der Erfindung. Die Vorrichtung 300 ist ähnlich der in Fig. 1 gezeigten Vorrichtung, umfasst jedoch zusätzlich einen Prozesssimulationsdatenanpasser 350. Der Prozesssimulationsdatenanpasser 350 ist mit dem Prozessparameterklassifikator 110 verbunden. Der Prozesssimulationsdatenanpasser 350 überträgt Prozesssimulationsdaten unterschiedlicher Prozesssimulationen der Mehrzahl von Prozesssimulationen, die auf unterschiedlichen Simulationsgittern basieren, auf ein gemeinsames Referenzgitter.

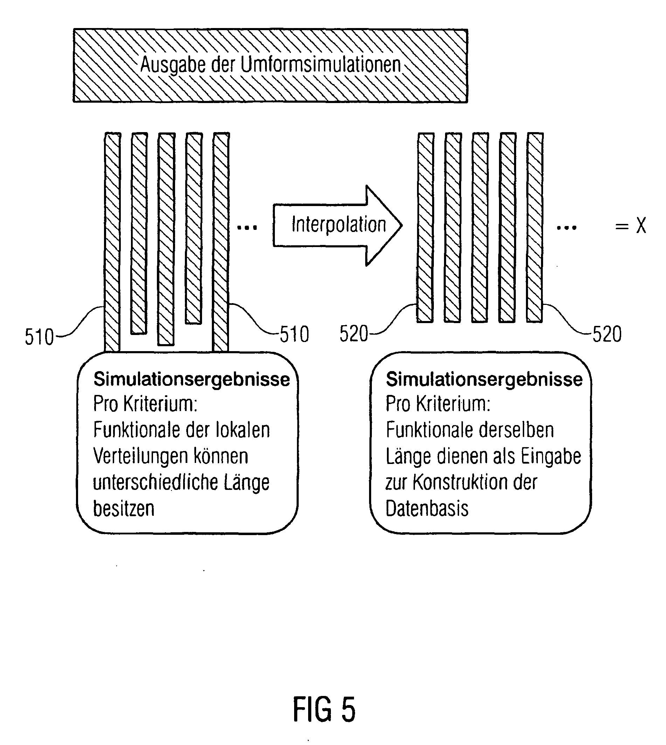

Bei der Berücksichtigung von unterschiedlichen Prozessparameterwerten können am Ende einer Prozesssimulation trotz anfänglich gleicher verwendeter Simulationsgitter unterschiedliche Endsimulationsgitter entstehen, auf denen die Prozesssimulationsdaten basieren, da ein Prozesssimulator während der Prozesssimulation das anfängliche Simulationsgitter je nach Verlauf der Simulation unterschiedlich verfeinern kann. Diese möglicherweise unterschiedlichen Simulationsgitter können durch den beschriebenen Prozesssimulationsdatenanpasser wieder auf ein gemeinsames Referenzgitter zurückgeführt werden. Fig. 5 zeigt dazu ein schematisches Beispiel einer Ausgabe (Output) einer Umformsimulation. Als Simulationsergebnis können pro Kriterium Funktionale 510 der lokalen Verteilungen unterschiedliche Längen (können auf unterschiedlich großen Simulationsgittern basieren) besitzen. Diese können durch Interpolation aneinander angepasst werden, so dass als Simulationsergebnis pro Kriterium Funktionale 520 derselben Länge als Eingabe zur Konstruktion der Datenbasis (z.B. einer Prozesssimulationsdatenmatrix X) dienen können.

Da der Prozesssimulationsdatenanpasser 350 dem zuvor beschriebenen Prozesssimulationsdatenbasiskonverter 230 ähnlich ist, können diese auch als eine Einheit implementiert werden, die beide Aufgaben erfüllt.

Allgemein gilt, der Prozessparameterklassifikator 110, der Prozesssimulationsdatenbearbeiter 120, der Prozesssimulator 230, der Prozesssimulationsdatenbasiskonverter 240 oder der Prozesssimulationsdatenbasisanpasser 350 können beispielsweise unabhängige Hardware-Einheiten oder Teil eines Prozesses, Mikrocontrollers oder Computers sowie Computerprogramme oder Software-Produkte zum Ausführen auf einem Prozessor, Mikrocontroller oder Computer sein.

Des Weiteren kann der dem Prozesssimulationen zugrunde liegende Prozess allgemein beispielsweise ein Herstellungsprozess, ein Bearbeitungsprozess, ein Verarbeitungsprozess, ein Umwandlungsprozess oder ein Umformungsprozess sein.

Im Folgenden wird das erfindungsgemäße Konzept in einem detaillierten Beispiel nochmals veranschaulicht, dass viele der zuvor erwähnten Aspekte der Erfindung in einer Anwendung zeigt.

Dabei wird ein Verfahren beschrieben, bei dem als erstes anhand eines parametrisierten Simulationsmodells mehrere Vorgänge (Designs) eines Prozessschrittes (eines Prozesses) simuliert werden, wobei jeder Vorgang (jedes Design) durch einen Satz von Werten der Design-Parameter (Prozessparameter) bestimmt ist. Die einzelnen Vorgänge, also die Sätze von Werten der Design-Parameter, werden z.B. nach einem Versuchsplan (design-ofexperiment, Entwurf des Experiments) bzw. einem iterativ erweiterten Versuchsplan ausgewählt.

Als zweites werden für die so entstehende Datenbasis aus Simulationsergebnissen - die aus Funktionswerten von mehreren unter Umständen zeitabhängigen Funktionen, welche auf unter Umständen hochaufgelösten Simulationsgittern leben, bestehen - die zu übertragenden Schwankungen, welche lokale Größen auf dem Gitter darstellen, interpoliert bzw. approximiert sowie komprimiert werden.

Als drittes werden das Mapping (die Übertragung) dieser so konstruierten Datenbasis inklusive Qualitätscheck mittels Verlust an Genauigkeit gegenüber der Größe der Variationen aufgrund von Parameter-Schwankungen, auf das Gitter (oder auch mehrere Gitter) für den nächsten Prozessschritt (Folgeprozesse), das (die) unter Umständen anders aufgelöst und geometrisch variierend auf Grund von Beschnitt oder ähnlichem ist (sind), erfolgt.

Die Schritte werden im Folgenden näher erläutert.

Als Versuchsplan kommen zum Beispiel, aber nicht nur Verfahren des Random Samplings (zufälliges Abtasten), Latin Hypercube, teil- oder voll-faktorielles Design usw. in Frage. Der Design-Raum (Bereich in dem die Prozessparameter variiert werden) bestimmt sich dabei aus einem Ausgangsdesign, welches dem Vorgang ohne Variation von Parametern entspricht, und den zu untersuchenden unteren und oberen Schranken pro Parameter. Es können Teilbereiche angegeben werden, die herausgenommen werden sollen. Es kann pro Parameter bereits eine Verteilungsfunktion für seinen Bereich angegeben sein, zum Beispiel Gauss-, Gleich- oder Weibull-Verteilung. Diese kann etwa aus physikalischen Experimenten oder theoretischen Überlegungen gewonnen werden.

Sofern die Simulationsergebnisse nicht bereits auf dem gleichen Gitter vorliegen, können diese auf ein oder auch mehrere Referenzgitter interpoliert bzw. approximiert werden (z.B. durch einen Prozesssimulationsdatenanpasser). Ein Referenzgitter kann zum Beispiel das in der Simulation resultierende letzte Gitter des Ausgangsdesigns oder eines anderen Designs sein. Falls dieses lokale Verfeinerungen enthält, können diese verwendet oder auch vorher entfernt werden. Zur Interpolation kann zum Beispiel das gleiche Verfahren wie für das Mapping (Verfahren zum Übertragen der Prozesssimulationsdatenbasis auf einen Folgeprozess) benutzt werden.

Pro Referenzgitter (z.B. eines für jeden simulierten Wert, wie z.B. eine Blechdicke, eine Spannung...) kann die Interpolation der Schwankungen der Simulationsresultate zum Beispiel mittels eines Verfahrens der Basistransformation durchgeführt werden, dazu zählen z.B. die Singulärwertzerlegung sowie kernbasierte Verfahren. Eine Singulärwertzerlegung der Matrix X wird durch $X=UWV^T$ dargestellt und bestehend aus den entsprechenden, u.U. interpolierten Simulationsresultaten. In diesem Fall werden die resultierenden Koeffizienten in V nachfolgend interpoliert bzw. approximiert. Hierbei können, sofern bekannt, Verteilungsfunktionen für die Parameterschwankungen miteinbezogen und über die Interpolation bzw. Approximation abgebildet werden.

Zur Interpolation bzw. Approximation (zum Bestimmen der Funktionale oder abgeleiteter Funktionale von neuen Prozessparameterwerten für einen Prozessparameter oder eine Mehrzahl von Prozessparametern) stehen viele bekannte Verfahren zur Verfügung, z.B. Verfahren aus den Klassen Metamodeling (Metamodellierung), Response Surface Model (Antwort-Flächen-Modell-Verfahren), (nonlinear) Regression ((nichtlineare) Regression), radial Basis Functions (radiale Basisfunktionen, (RBF)), Kriging, Wavelets, Self Organising Maps (selbstorganisierende Karten, (SOM)), Support Vector Machines (Stützvektormaschinen, (SVM)) oder neural networks (Neuronale Netze)..

Zur Kompression (oder Reduzierung) der Datenbasis der Simulationsresultate kann zum Beispiel direkt das Resultat der Basistransformation verwendet werden. Hierbei kann durch eine Toleranzschranke durch den Benutzer festgelegt werden, mit welcher Genauigkeit die Informationen aus allen Parametervariationen erhalten bleiben. Darüber hinausführend kann der Benutzer eine mathematisch definierte Norm angeben, die zur Fehlerberechnung genutzt werden soll. Hierbei kann er z.B. nicht interessante Gebiete des Gitters schwächer gewichten um den Schwerpunkt auf die interessanten Gebiete zu legen. Z. B. im Falle der Singulärwertzerlegung lässt sich der entstehende Fehler mittels des Parseval Kriteriums berechnen. Die Kompression erfolgt dann genauer durch das Setzen der Singulärwerte $w_1$ auf Null, startend von einer Zahl k+1, die Singulärwerte $w_1$ werden durch die Diagonalelemente der Matrix W repräsentiert. Die entstehende Rekonstruktion der Matrix X enthält eine Abweichung dX von X. Die Genauigkeit dieser Rekonstruktion lässt sich über k kontrollieren, die $L_2$-Norm dieser Abweichung beträgt

$$err^2 = \sum_{ij} dx_{ij}^2 = \sum_{l=k+1}^{N} w_l^2 \,,$$

d.h. die Summe der Quadrate der ausgelassenen Singulärwerte. Dadurch kann auch ein Genauigkeitskriterium definiert werden. Gewöhnlich sinken die Singulärwerte schnell mit k, s.d. nur einige wenige Werte (z.B. nur 3-7 Werte bei 25 Prozesssimulationen oder etwa 10-30% der Anzahl von Prozesssimulationen) erhalten bleiben müssen, um eine geeignete Genauigkeit zu erhalten. Im Falle der Singulärwertzerlegung können die Zerlegung und die Kompression gleichzeitig stattfinden, so dass insgesamt direkt nur die ersten k Komponenten berechnet werden müssen.

Der wesentliche Schritt des Verfahrens ist es, die Datenbasis so aufzubereiten, dass die komplett lokale Übertragung aller Schwankungsinformationen auf den nächsten Prozessschritt überhaupt effizient hinsichtlich Anzahl notwendiger Simulationen und Rechenzeit für das Verfahren selbst ermöglicht wird. Diese Aufbereitung kann dazu z.B. in zwei Fälle unterteilt werden. Im ersten Falle wirken sich die Parameter-Schwankungen linear oder nur schwach nichtlinear auf die Simulationsresultate aus, im zweiten Fall stärker nichtlinear. Das Maß der Nichtlinearität kann zum Beispiel über eine Methode zur Sensitivitätsanalyse für die Wirkung von Parametervariationen auf die Simulationsresultate bestimmt werden. Hierzu können z.B. Taylorreihenapproximationen herangezogen werden. Konkreter werden zum Beispiel Approximationen für die Jacobimatrix J und die Hessematrix H berechnet,

$$J_{ik} = \partial x_i / \partial par_k \qquad H_{jk}^{(i)} = \partial^2 x_i / (\partial par_j \partial par_k) \,.$$

Auch hier kann direkt das Ergebnis der Basistransformation verwendet werden, im Falle der Singulärwertzerlegung werden die Koeffizienten in V betrachtet.

Als Schätzer für den Grad der Nichtlinearität kann folgendes Maß verwendet werden, falls die Hessematrix Null oder annähernd Null ist, ist das Verhalten als linear bzw. schwach nichtlinear anzusehen. Falls gilt

$$J^{(i)} < \frac{D}{4} H_{\max}^{(i)},$$

sollte das Verhalten als nichtlinear angesehen werden. Hierbei ist $J^{(i)} = \sqrt{\sum_j J_{ij}^2}$, , $D$ der Durchmesser der Region, in der die Parameter variiert wurden, und $H_{\max}^{(i)}$ der maximale absolute Eigenwert von $H_{jk}^{(i)}$. Über eine Sensitivitätsanalyse können zudem diejenigen Parameter bestimmt werden, deren Schwankungen keine für den Benutzer relevanten Auswirkungen zeigen und daher nicht weiter untersucht werden müssen.

Daher kann das Verfahren so ablaufen, dass zuerst diejenigen Parameter bestimmt werden, deren Schwankungen sich in relevantem Umfang linear oder schwach nichtlinear auswirken. Für diese Parameter kann eine einfache Interpolations- bzw. Approximationsmethode für die resultierenden Schwankungen der Simulationsresultate verwendet werden. Für Parameter, deren Schwankungen sich in relevantem Umfang stärker nichtlinear auswirken, können aufwändigere Interpolations- bzw. Approximationsverfahren mit mehr Stützstellen, also Simulationen, verwendet werden. Die noch fehlenden Simulationen werden dazu durchgeführt, d.h. der Versuchsplan wird iterativ erweitert. Zum Beispiel kann für diese Parameter ein gemeinsamer Versuchsplan zur Bestimmung von Stützstellen verwendet werden. Es können außerdem Verfahren zum Einsatz kommen, welche das Simulationsgebiet nach definierten Kriterien aufteilen, zum Beispiel nach Einfluss einer bestimmten Größe bzw. maximalen oder minimalen Größen. Über die Interpolations- bzw. Approximationsmethode wird dann pro Teilgebiet entschieden. Es sollte dann ein stetiger Übergang zwischen den Teilgebieten geschaffen werden, z.B. durch den Einsatz von Decay-Funktionen.

Das Mapping (die Übertragung der bearbeiteten Prozesssimulationsdatenbasis auf einen Folgeprozess) kann durch ein beliebiges Interpolations- bzw. Approximationsverfahren durchgeführt werden. Allerdings sollte die Güte des Mappings durch einen Qualitätscheck überprüft werden. Die zusätzlich durch das Mapping hinzukommenden Fehler ε sollten - jedenfalls in den für den Benutzer relevanten Bereichen der Gitter - deutlich kleiner sein als die Schwankungen σ, die durch die Parametervariationen entstanden sind, um aussagekräftige statistische Aussagen für den oder die nachfolgenden Prozessschritte zu erhalten.

Eine grobe (globale) Schätzung von Schwankungen bzw. die einfache Annahme einer statistischen Verteilung einer Größe auf dem Gitter als Eingangsgröße für den nächsten Prozessschritt, die meist ungenau ist und nicht der Realität entspricht, führt zu Fehlern und ungenauem bis falschem Einschätzen der resultierenden Schwankungen.

Die Erfindung erlaubt es dagegen, beispielsweise die Wirkung von Design-Parameter-Schwankungen (Prozessparameterschwankung) über die Historie des Prozesses zu verfolgen und insbesondere auch für den letzten Prozessschritt zu quantifizieren und zu analysieren. Die zu Beginn des Prozesses entstehenden Schwankungen können über den gesamten Prozess mitgenommen werden. Dadurch kann der Entwicklungsingenieur für Teile oder auch die Gesamtheit des Produktions- bzw. Wirkungsprozesses die Auswirkungen von Schwankungen analysieren und bekommt damit einen Eindruck für die gesamte Prozesskette und einen Ansatzpunkt für die Veränderung von Design-Parametern zur Erhaltung eines gegenüber Parameter-Schwankungen robusten Resultates. Mit Hilfe dieser Erfindung kann durch die Berücksichtigung der Historie des Prozesses und seiner Parametervariationen die Qualität der Simulationen und durch nachfolgende robuste Optimierung die Qualität des gesamten Prozesses erheblich verbessert werden.

Das erfindungsgemäße Konzept lässt sich z.B. im Bereich numerischer Simulation von Produktions- bzw. Wirkungsprozessen anwenden, sofern zu untersuchende Änderungen eines Ausgangsdesigns parametrisiert werden können. Als Anwendungsfelder sind insbesondere, aber nicht nur Prozessketten in der Automobilindustrie, wie zum Beispiel Umformen-Crash (Umformen-Unfall), Umformen-NVH (Noise, Vibration, Harshness oder Geräusch, Vibration, Rauigkeit), Umformen-Statik, Gießen-Crash, Gießen-NVH, Gießen-Statik usw. sowie mehrschrittige Umformprozesse, und die Kette Halbleiter-Prozess-Bauelement-Schaltungssimulation aus der Mikroelektronik zu nennen. Zudem kommen alle Prozessketten in Frage, in denen in mehreren Schritten ein naturwissenschaftlichtechnischer Prozess simuliert wird, bei dem das Produkt über Design-Parameter auf Gittern, welche unter Umständen hochaufgelöst sind, in diesen Schritten definiert ist. Die notwendigen Daten können jeweils durch numerische Simulation und Einlesen der Simulationsresultate bereitgestellt werden.

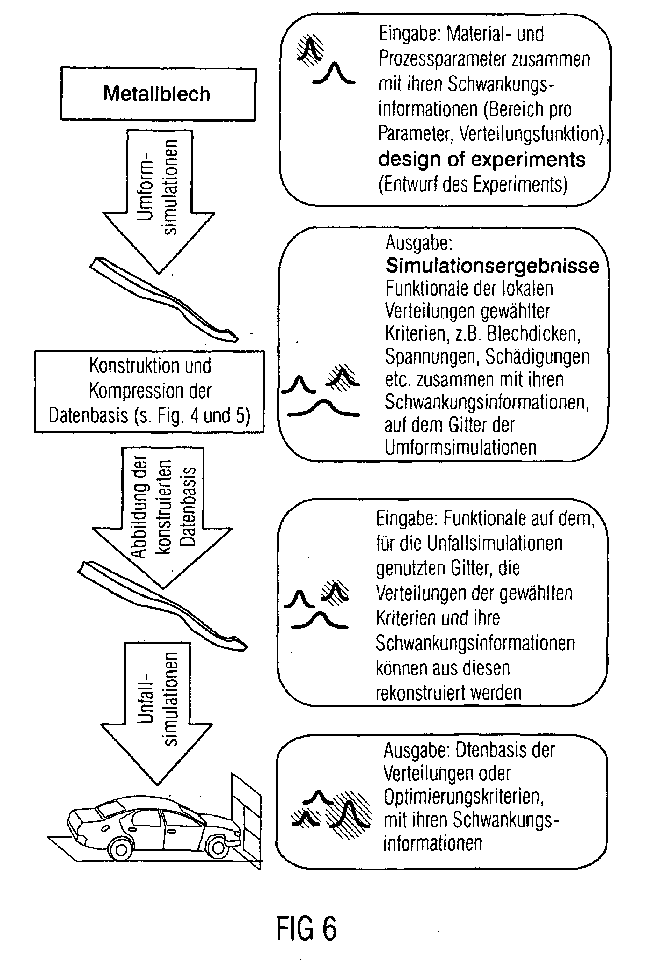

Das erfindungsgemäße Konzept wird nachfolgend anhand eines Ausführungsbeispiels unter Bezugnahme auf die Fig. 4 bis 6 näher erläutert. In der Fig. 6 ist dabei der Ablauf des Verfahrens anhand des Beispiels der Prozesskette Umformen-Crash für die Haupt-Blechschale einer B-Säule schematisch dargestellt. Der Crash-Schritt ist nur symbolisch angedeutet. Die Fig. 4 und 5 stellen detaillierter den Schritt der Konstruktion der Datenbasis dar, beispielhaft für den Fall, dass eine Singulärwertzerlegung angewandt wird.

Als Input (Eingangsdaten) werden verschiedene Material- und Prozessparameter festgelegt, zum Beispiel 15 Stück, zusammen mit dem zulässigen Schwankungsbereich bzw. einer Verteilungsfunktion pro Parameter. In den folgenden Umformsimulationen werden die Werte der Parameter einem Versuchsplan gemäß variiert. In der Fig. 6 wird ein Blech zu einem Bauteil eines Fahrzeuges umgeformt. Als Output (Ausgangsdaten) dieses ersten Prozessschritts erhält man dann die lokalen Verteilungen bestimmter Kriterien, die in diesem Beispiel lokale Blechdicken, Spannungen und Schädigungen sind, zusammen mit ihren durch die Parameter-Variationen entstandenen lokalen Schwankungen auf den in den Umformsimulationen resultierenden, unterschiedlich lokal verfeinerten Gittern. Diese Datenbasis wird nun analysiert, ggf. reduziert bzw. komprimiert. Die relevanten Daten für den Transfer auf den nächsten Prozessschritt Crash bestehen in diesem Beispiel aus der konstruierten Datenbasis, die Funktionale enthält mittels derer lokale Verteilungen der Blechdicke, plastischen Dehnungen und Schädigungen zusammen mit ihren interpolierten lokalen Schwankungen rekonstruiert werden können.

Dann wird das Mapping (Übertragung) dieser neu konstruierten Datenbasis auf das Gitter des nächsten Prozessschrittes durchgeführt, in diesem Beispiel eine Crash-Simulation, die auf einem wesentlich gröberen und beschnittenen Gitter basiert. Dieser Übertragungsschritt der Schwankungen bedeutet, dass nun als Input lokal auf dem Crashgitter, d.h. in jedem Knotenpunkt, die Werte für die Blechdicken, Spannungen und Schädigungen, zusammen mit ihrem jeweiligen Schwankungsband (bzw. ihrer Schwankungsverteilung) bereitstehen. Im zweiten Prozessschritt werden konsistente Simulationen durchgeführt, als Output können lokale oder globale Kriterien definiert werden, vor allem aber sind auch hier die kompletten Schwankungsinformationen für die auf dem (den) Crashgitter(n) definierten Simulationsresultate verfügbar. Ein Vergleich verschiedener Szenarien, auch mit Resultaten physikalischer Experimente, zeigt in diesem Beispiel sowohl die Güte der Crash-Simulationsresultate dank Hinzunahme der Historie aus der Umformsimulation inklusive fein aufgelöster Schwankungen sowie insbesondere den hohen Einfluss der Schwankungen in den kritischen Regionen (Riss- und Knick-Zonen) des geformten Blechteils im Crash-Experiment.

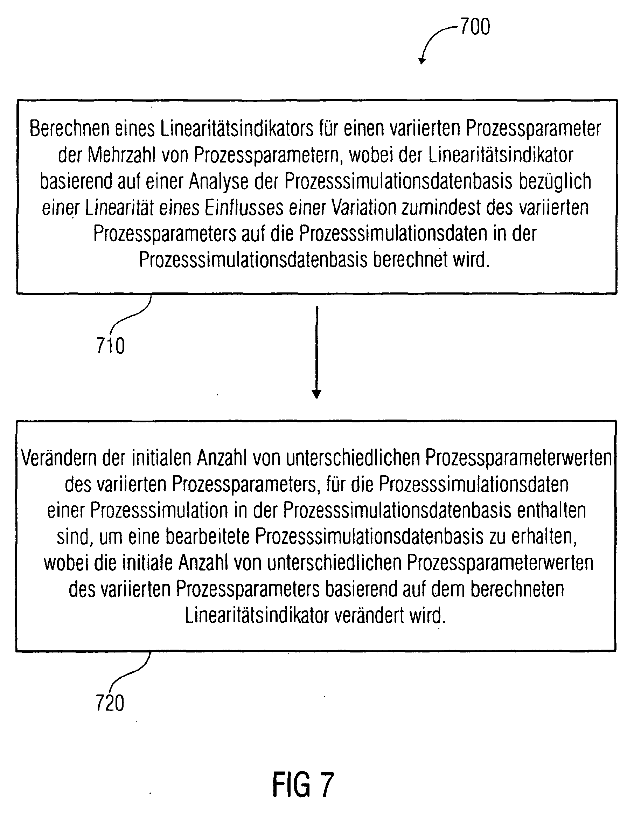

Fig. 7 zeigt ein Flussdiagramm eines Verfahrens 700 zum Bearbeiten einer Prozesssimulationsdatenbasis eines Prozesses entsprechend einem Ausführungsbeispiel gemäß der Erfindung. Die Prozesssimulationsdatenbasis des Prozesses umfasst Prozesssimulationsdaten einer Mehrzahl von Prozesssimulationen, wobei jede Prozesssimulation der Mehrzahl von Prozesssimulationen auf einer unterschiedlichen Variation einer Mehrzahl von Prozessparametern basiert. Für jeden Prozessparameter der Mehrzahl von Prozessparametern sind für eine initiale Anzahl von unterschiedlichen Prozessparameterwerten Prozesssimulationsdaten einer Prozesssimulation in der Prozesssimulationsdatenbasis enthalten. Das Verfahren 700 umfasst ein Berechnen 710 eines Linearitätsindikators für einen variierten Prozessparameter der Mehrzahl von Prozessparametern und ein Verändern 720 der initialen Anzahl von unterschiedlichen Prozessparameterwerten des variierten Prozessparameters. Dabei erfolgt die Berechnung 710 des Linearitätsindikators für den variierten Prozessparameter der Mehrzahl von Prozessparametern basierend auf einer Analyse der Prozesssimulationsdatenbasis bezüglich einer Linearität eines Einflusses einer Variation zumindest des variierten Prozessparameters auf die Prozesssimulationsdaten in der Prozesssimulationsdatenbasis. Des Weiteren erfolgt das Verändern 720 der initialen Anzahl von unterschiedlichen Prozessparameterwerten des variierten Prozessparameters, für die Prozesssimulationsdaten einer Prozesssimulation in der Prozesssimulationsdatenbasis enthalten sind, basierend auf dem berechneten Linearitätsindikator, um eine bearbeitete Prozesssimulationsdatenbasis zu erhalten.

Das Verfahren 700 kann optional um zusätzliche Schritte erweitert werden, die den zuvor beschriebenen Aspekten des erfindungsgemäßen Konzept entsprechen.

Einige Ausführungsbeispiele gemäß der Erfindung beziehen sich auf ein Verfahren zur Schwankungsübertragung, resultierend aus Design(Entwurf)-Parameter-Schwankungen (Prozessparameterschwankung), zwischen einzelnen Prozessschritten (Prozessen) von Prozessketten.

Die vorliegende Erfindung betrifft unter anderem ein Verfahren zur lokalen Schwankungsübertragung, resultierend aus Design-Parameter-Schwankungen, zwischen den einzelnen Prozessschritten von ganzen Prozessketten. Allgemeiner betrifft die Erfindung unter anderem ein Verfahren zur lokalen Übertragung von Schwankungen von diskreten Funktionen auf hochaufgelösten Gittern zwischen zwei Prozessschritten auf gegebenenfalls unterschiedlichen Gittern; dieses Verfahren kann mehrfach hintereinander angewandt werden und betrifft somit ganze Prozessketten aus zwei oder mehr Schritten.

Durch das erfindungsgemäße Konzept kann ein Verfahren realisiert werden, mit dem sich die Wirkung von Schwankungen (Variationen) von Design-Parametern über die gesamte Historie eines Produktions- bzw. Wirkungsprozesses, d.h. über mehrere Prozessschritte hinweg auf das Endresultat, analysieren lässt.

Dazu wird z.B. mit der Erfindung ein Verfahren zur Schwankungsübertragung für ganze Prozessketten vorgeschlagen, bei dem - beispielhaft für, aber nicht beschränkt auf eine Kette bestehend aus zwei Prozessschritten - der Transfer zwischen den beiden Prozessschritten durchgeführt wird, sowohl für den Fall, dass sich die Design-Parameter-Schwankungen linear, als auch für den Fall, dass sich diese nichtlinear auf das Endprodukt auswirken.

Einige weitere Ausführungsbeispiele gemäß der Erfindung beziehen sich auf ein Verfahren zur stochastischen Analyse ganzer Prozessketten und insbesondere zur Übertragung von lokalen Schwankungen auf unter Umständen hochaufgelösten Simulationsgittern, resultierend aus Design-Parameter-Schwankungen, zwischen den einzelnen Prozessschritten von ganzen Prozessketten, bei dem anhand eines parametrisierten Simulationsmodells mehrere Vorgänge des ersten Prozessschrittes simuliert werden, für die so entstehende Datenbasis aus Simulationsergebnissen die zu übertragenden Schwankungen, welche lokale Größen auf dem jeweiligen Simulationsgitter darstellen, aufbereitet, das heißt interpoliert bzw. approximiert und bei Bedarf auch komprimiert werden, die Aufbereitung, falls sie in zwei Fälle aufgeteilt wird, im Falle linearer oder schwach nichtlinearer Auswirkungen von einzelnen Parameterschwankungen für diese durch eine Interpolations- bzw. Approximationsmethode, wie z.B. eine Singulärwertzerlegung mit wenigen Stützstellen, durchgeführt wird, die Aufbereitung generell oder, falls sie in zwei Fälle aufgeteilt wird, im Falle stärker nichtlinearer Auswirkungen von einzelnen Parameterschwankungen für diese durch eine Interpolations- bzw. Approximationsmethode, wie z.B. eine Singulärwertzerlegung von Simulationsresultaten, basierend auf einem gemeinsamen Versuchsplan für die Parameter, mit nachfolgender aufwändigerer Interpolation der Koeffizienten, durchgeführt wird, das Mapping dieser Datenbasis inklusive Qualitätscheck hinsichtlich Verlust an Genauigkeit gegenüber der Größe der Variationen aufgrund von Parameterschwankungen, auf das oder die Gitter, welche eingangs des nächsten Prozessschrittes verwendet werden sollen, erfolgt.

Dabei können die Vorgänge jeweils eine Variation eines Design-Parameters beinhalten und die einzelnen Vorgänge nach einem beliebigen Versuchsplan ausgewählt sein. Die Design-Parameter-Schwankungen können dabei jeweils linear oder auch nichtlinear auf das Endprodukt einwirken.

Gemäß einem Aspekt der Erfindung können die Design-Parameter-Schwankungen lokal auf dem gesamten relevanten Gitter auf den nächsten Prozessschritt übertragen werden. Das Mapping (Übertragung oder Abbildung) kann zwischen Gittern mit eventuell unterschiedlicher Auflösung oder Geometrie, z.B. aufgrund von Beschnitt, durchgeführt werden.

Die Design-Parameter-Schwankungen können lokal über mehrere Schritte hinweg transferiert werden und damit die Historie kompletter Prozessketten im finalen Prozessschritt berücksichtigt werden.

Das Gitter kann nach definierten Kriterien in verschiedene Gebiete unterteilt werden (z.B. nach Einfluss einer bestimmten Größe) und die Interpolation bzw. Approximation der Schwankungen kann lokal pro Gebiet, unter Umständen mit stetiger oder stetig differenzierbaren Übergängen zwischen den Teilgebieten, stattfinden.

Bei einigen Ausführungsbeispielen der Erfindung berechnet der Prozessparameterklassifikator 110 den Linearitätsindikator des variierten Prozessparameters basierend auf einem kernbasierten Verfahren oder basierend auf einer Singulärwertzerlegung einer Prozesssimulationsdatenmatrix X, wobei die Prozesssimulationsdatenmatrix X die Prozesssimulationsdatenbasis 102 repräsentiert.

Gemäß einem weiteren Aspekt kann der Prozessparameterklassifikator 110 den Linearitätsindikator des variierten Prozessparameters basierend auf einer Sensitivitätsanalyse der Prozesssimulationsdatenbasis 102 unter Variation der Prozessparameter der Mehrzahl von Prozessparametern berechnen.

Ebenso kann der Prozesssimulationsdatenbearbeiter 120 die Prozesssimulationsdatenbasis 102 basierend auf einer Vernachlässigung von Diagonalelementen einer Diagonalmatrix W der Singulärwertzerlegung reduzieren oder komprimieren.

Bei einigen Ausführungsbeispielen berechnet der Prozessparameterklassifikator 110 ausgelegt ist, um für jeden Prozessparameter der Teilmenge von variierten Prozessparametern einen Eigenvektor mit zugehörigem Eigenwert $\lambda_1$, so dass jeder Eigenvektor nur von jeweils einem Prozessparameter der Teilmenge von variierten Prozessparametern abhängt und von den anderen Prozessparametern der Teilmenge von Prozessparametern unabhängig ist, und ist ausgelegt, um für jeden Eigenwert $\lambda_1$, der Eigenvektoren einen Linearitätsindikator basierend auf dem jeweiligen Eigenwert $\lambda_1$ zu berechnen und mit einem auf der Jacobmatrix J basierenden Vergleichsparameter zu vergleichen, um einen Eigenwert $\lambda_1$ zu bestimmen, für den ein Nicht-Linearitätskriterium erfüllt ist, und um den zugehörigen Prozessparameter der ersten linearitätsabhängigen Klasse von Prozessparametern zuzuordnen.

Gemäß einem weiteren Aspekt berechnet der Prozessparameterklassifikator 110 eine Jacobimatrix J, wobei die Jacobimatrix J ein Maß für die erste Ableitung der Prozesssimulationsdaten unter Variation der Mehrzahl von Prozessparametern angibt, um den variierten Prozessparameter basierend auf einem Vergleich des Einflussstärkeindikators mit einem auf einer Spalte der Jacobimatrix J basierenden Vergleichsparameter der ersten einflussabhängigen Klasse von Prozessparametern oder der zweiten einflussabhängigen Klasse von Prozessparametern zuzuordnen. Dabei basiert der Einflussstärkeindikator auf einer Spalte der Jacobimatrix J, die ein Maß für die erste Ableitung von Prozesssimulationsdaten unter Variation des variierten Prozessparameters angibt.

Bei einigen Ausführungsbeispielen berechnet der Prozessparameterklassifikator 110 für jeden Prozessparameter der Mehrzahl von Prozessparametern einen Linearitätsindikator oder eine Einflussstärkeindikator.

Einige Ausführungsbeispiele weisen einen Prozesssimulator 230 auf, der den Prozess für eine Kombination von Prozessparameterwerten der Mehrzahl von Prozessparametern simulieren kann, um Prozesssimulationsdaten für die Kombination von Prozessparameterwerten zu erhalten und der Prozesssimulationsdatenbasis 102 hinzuzufügen.

Zusätzlich kann der Prozesssimulationsdatenbearbeiter 120 zwei unterschiedliche Prozessparameterwerte für den variierten Prozessparameter bestimmen, wenn der variierte Prozessparameter der zweiten linearitätsabhängigen Klasse von Prozessparametern und der ersten einflussabhängigen Klasse von Prozessparametern zugeordnet ist. Der Prozesssimulator 230 kann dabei für die beiden bestimmten Prozessparameterwerte des variierten Prozessparameters in Kombination mit einer Variation der restlichen Prozessparameter der Mehrzahl von Prozessparametern neue Prozesssimulationsdaten erzeugen und die alten Prozesssimulationsdaten in der Prozesssimulationsdatenbasis 102 durch die neuen Prozesssimulationsdaten ersetzen.

Ebenso kann der Prozesssimulationsdatenbearbeiter 120 zumindest drei Prozessparameterwerte für den variierten Prozessparameter bestimmen, wenn der variierte Prozessparameter der ersten linearitätsabhängigen Klasse zugeordnet ist, wobei zumindest ein bestimmter Prozessparameterwert nicht bereits von der initialen Anzahl von Prozessparameterwerten des variierten Prozessparameters enthalten ist. Dabei kann der Prozesssimulator 230 für alle bestimmten Prozessparameterwerte, die nicht bereits von der initialen Anzahl von Prozessparameterwerten des variierten Prozessparameters enthalten sind, in Kombination mit einer Variation der restlichen Prozessparameter der Mehrzahl von Prozessparametern neue Prozesssimulationsdaten erzeugen und der Prozesssimulationsdatenbasis 102 hinzuzufügen. Zusätzlich kann der Prozesssimulationsdatenbearbeiter 120 Prozesssimulationsdaten von Prozessparameterwerten, die nicht vom Prozesssimulationsdatenbearbeiter 120 bestimmt wurden, aus der Prozesssimulationsdatenbasis 102 entfernen.

Optional kann der Prozesssimulationsdatenbearbeiter 120 auch die Ergebnisse für einen variierten Prozessparameterwert oder eine Mehrzahl von variierten Prozessparameterwerten interpolieren oder approximieren, basierend auf einer Metamodellierung, eines Antwort-Flächen-Modells, einer nichtlinearen Regression, radialen Basisfunktionen, Kriging, Wavelets, selbstorganisierenden Karten, Stützvektormaschinen oder neuronalen Netzen.

Ferner kann der Prozesssimulator 230 die Prozesssimulationsdaten der Prozesssimulationsdatenbasis 102 für die unterschiedlichen Variationen der Mehrzahl von Prozessparametern erzeugen, wobei die Mehrzahl von Prozessparametern basierend auf einem Versuchsplan variiert werden können.

Einige Ausführungsbeispiele weisen einen Prozesssimulationsdatenanpasser 350 auf, der Prozesssimulationsdaten unterschiedlicher Prozesssimulationen der Mehrzahl von Prozesssimulationen, die auf unterschiedlichen Simulationsgittern basieren, auf ein gemeinsames Referenzgitter übertragen kann.

Allgemein kann der den Prozesssimulationen zugrunde liegende Prozess ein Produktionsprozess, ein Herstellungsprozess, ein Bearbeitungsprozess, ein Verarbeitungsprozess, ein Umwandlungsprozess oder ein Umformungsprozess sein.

Einige Ausführungsbeispiele beziehen sich auf eine Vorrichtung 300 zum Erzeugen einer Prozesssimulationsdatenbasis 242 für eine Prozesssimulation eines Folgeprozesses eines Prozesses, für den Prozesssimulationen für eine unterschiedliche Variation einer Mehrzahl von Prozessparametern des Prozesses berücksichtigt werden. Die Vorrichtung umfasst einen Prozesssimulator 230, der um Prozesssimulationsdaten für die unterschiedlichen Variationen der Mehrzahl von Prozessparameter des Prozesses erzeugen kann, um eine Prozesssimulationsdatenbasis 102 des Prozesses zu erhalten. Ferner weist die Vorrichtung 300 eine Vorrichtung zum Bearbeiten einer Prozesssimulationsdatenbasis 102 eines Prozesses gemäß dem beschriebenen Konzept auf, die die von dem Prozesssimulator 230 erzeugte Prozesssimulationsdatenbasis 102 des Prozesses bearbeiten kann. Zusätzlich umfasst die Vorrichtung 300 einen Prozesssimulationsdatenbasiskonverter, der die bearbeitete Prozesssimulationsdatenbasis 122 auf ein Simulationsgitter für eine Prozesssimulation eines Folgeprozesses übertragen kann, um die Prozesssimulationsdatenbasis 242 für die Prozesssimulation des Folgeprozesses zu erzeugen, wobei das Simulationsgitter von dem Folgeprozesses abhängt.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein. Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft. Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft. Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Patentansprüche**

1. Vorrichtung (100, 200, 300) zum Bearbeiten einer Prozesssimulationsdatenbasis (102) eines Prozesses, die Prozesssimulationsdaten einer Mehrzahl von Prozesssimulationen des Prozesses umfasst, wobei jede Prozesssimulation der Mehrzahl von Prozesssimulationen auf einer unterschiedlichen Variation einer Mehrzahl von Prozessparametern basiert, wobei für jeden Prozessparameter der Mehrzahl von Prozessparametern für eine initiale Anzahl von unterschiedlichen Prozessparameterwerten Prozesssimulationsdaten einer Prozesssimulation in der Prozesssimulationsdatenbasis (102) enthalten sind, mit folgenden Merkmalen:

    einem Prozessparameterklassifikator (110), der ausgelegt ist, um für einen variierten Prozessparameter der Mehrzahl von Prozessparametern einen Linearitätsindikator basierend auf einer Analyse der Prozesssimulationsdatenbasis (102) bezüglich einer Linearität eines Einflusses einer Variation zumindest des variierten Prozessparameters auf die Prozesssimulationsdaten in der Prozesssimulationsdatenbasis zu berechnen; und
    einem Prozesssimulationsdatenbearbeiter (120), der ausgelegt ist, um die initiale Anzahl von unterschiedlichen Prozessparameterwerten des variierten Prozessparameters, für die Prozesssimulationsdaten einer Prozesssimulation in der Prozesssimulationsdatenbasis (102) enthalten sind, basierend auf dem berechneten Linearitätsindikator zu verändern, um eine bearbeitete Prozesssimulationsdatenbasis (122) zu erhalten.

2. Vorrichtung gemäß Anspruch 1, wobei der Prozessparameterklassifikator (110) ausgelegt ist, um den variierten Prozessparameter einer ersten linearitätsabhängigen Klasse von Prozessparametern zuzuordnen, wenn ein berechneter Linearitätsindikator des variierten Prozessparameters ein vordefiniertes Nicht-Linearitätskriterium erfüllt, oder der Prozessparameterklassifikator (110) ausgelegt ist, um den variierten Prozessparameter einer zweiten linearitätsabhängigen Klassen von Prozessparametern zuzuordnen, wenn der berechnete Linearitätsindikator des variierten Prozessparameters das vordefinierte Nicht-Linearitätskriterium nicht erfüllt, wobei ein Prozessparameter der der ersten linearitätsabhängigen Klasse von Prozessparametern zugeordnet ist einen stärkeren nichtlinearen Einfluss auf die Prozesssimulationsdaten in der Prozesssimulationsdatenbasis (102) aufweist als ein Prozessparameter der der zweiten linearitätsabhängigen Klasse von Prozessparametern zugeordnet ist.

3. Vorrichtung gemäß Anspruch 2, wobei der Prozesssimulationsdatenbearbeiter (120) ausgelegt ist, um die initiale Anzahl von unterschiedlichen Prozessparameterwerten des variierten Prozessparameters zu verändern, so dass eine veränderte Anzahl von unterschiedlichen Prozessparameterwerten des variierten Prozessparameters kleiner ist, wenn der variierte Prozessparameter der zweiten linearitätsabhängigen Klasse von Prozessparametern zugeordnet ist, als eine veränderte Anzahl von unterschiedlichen Prozessparameterwerten des variierten Prozessparameters, wenn der variierte Prozessparameter der ersten linearitätsabhängigen Klasse von Prozessparametern zugeordnet ist.

4. Vorrichtung gemäß einem der Ansprüche 1 bis 3, wobei der Prozessparameterklassifikator (110) ausgelegt ist, um für den variierten Prozessparameter einen Einflussstärkeindikator basierend auf einer Analyse der Prozesssimulationsdatenbasis (102) bezüglich einer Stärke eines Einflusses einer Variation zumindest des variierten Prozessparameters auf die Prozesssimulationsdaten in der Prozesssimulationsdatenbasis (102) zu berechnen, und ausgelegt ist, um den variierten Prozessparameter einer ersten einflussabhängigen Klasse von Prozessparametern zuzuordnen, wenn der Einflussstärkeindikator ein minimales Einflusskriterium erfüllt, oder um den variierten Prozessparameter einer zweiten einflussabhängigen Klasse von Prozessparametern zuzuordnen, wenn der Einflussstärkeindikator das minimale Einflusskriterium nicht erfüllt, wobei ein Prozessparameter, der der ersten einflussabhängigen Klasse von Prozessparametern zugeordnet ist, einen stärkeren Einfluss auf die Prozesssimulationsdaten in der Prozesssimulationsdatenbasis aufweist als ein Prozessparameter, der der zweiten einflussabhängigen Klasse von Prozessparametern zugeordnet ist.

5. Vorrichtung gemäß Anspruch 4, wobei der Prozesssimulationsdatenbearbeiter (120) ausgelegt ist, um die initiale Anzahl von unterschiedlichen Prozessparameterwerten des variierten Prozessparameters zu verändern, so dass eine veränderte Anzahl von unterschiedlichen Prozessparameterwerten des variierten Prozessparameters kleiner ist, wenn der variierte Prozessparameter der zweiten einflussabhängigen Klasse von Prozessparametern zugeordnet ist, als eine veränderte Anzahl von unterschiedlichen Prozessparameterwerten des variierten Prozessparameters, wenn der variierte Prozessparameter der ersten einflussabhängigen Klasse von Prozessparametern zugeordnet ist.

6. Vorrichtung gemäß Anspruch 4 oder 5, wobei der Prozessparameterklassifikator (110) ausgelegt ist, um zuerst den variierten Prozessparameter der ersten linearitätsabhängigen Klasse oder der zweiten linearitätsabhängigen Klasse zuzuordnen und danach den variierten Prozessparameter der ersten einflussabhängigen Klasse oder der zweiten einflussabhängigen Klasse zuzuordnen, wenn der variierte Prozessparameter zuerst der zweiten linearitätsabhängigen Klasse zugeordnet wurde.

7. Vorrichtung gemäß Anspruch 6, wobei der Prozesssimulationsdatenbearbeiter (120) ausgelegt ist, um die initiale Anzahl von unterschiedlichen Prozessparameterwerten des variierten Prozessparameters auf zwei unterschiedliche Prozessparameterwerte des variierten Prozessparameters zu reduzieren, für die Prozesssimulationsdaten einer Prozesssimulation in der Prozesssimulationsdatenbasis enthalten sind, wenn der variierte Prozessparameter der zweiten linearitätsabhängigen Klasse von Prozessparametern und der ersten einflussabhängigen Klasse von Prozessparametern zugeordnet ist, oder der Prozesssimulationsdatenbearbeiter (120) ausgelegt ist, um die initiale Anzahl von unterschiedlichen Prozessparameterwerten des variierten Prozessparameters auf einen einzigen Prozessparameterwert des variierten Prozessparameters zu reduzieren, für den Prozesssimulationsdaten einer Prozesssimulation in der Prozesssimulationsdatenbasis enthalten sind, wenn der variierte Prozessparameter der zweiten linearitätsabhängigen Klasse und der zweiten einflussabhängigen Klasse zugeordnet ist.

8. Vorrichtung gemäß einem der Ansprüche 1 bis 7, wobei der Prozessparameterklassifikator (110) ausgelegt ist, um den Linearitätsindikator des variierten Prozessparameters basierend auf einer Hessematrix (H) zu berechnen, wobei die Hessematrix (H) ein Maß für die partielle Ableitung zweiter Ordnung der Prozesssimulationsdaten unter Variation der Mehrzahl von Prozessparametern angibt.

9. Vorrichtung gemäß Anspruch 8, wobei der Prozessparameterklassifikator (110) ausgelegt ist, um eine Jacobmatrix (J) zu berechnen, wobei die Jacobimatrix (J) ein Maß für die erste Ableitung der Prozesssimulationsdaten unter Variation der Mehrzahl von Prozessparametern angibt, wobei der Prozessparameterklassifikator (110) ausgelegt ist, um den variierten Prozessparameter basierend auf einem Vergleich eines auf der Jacobmatrix (J) basierenden Vergleichsparameters mit dem auf der Hessematrix (H) basierenden Linearitätsindikator der ersten linearitätsabhängigen Klasse von Prozessparametern oder der zweiten linearitätsabhängigen Klasse von Prozessparametern zuzuordnen.

10. Vorrichtung gemäß Anspruch 9, wobei der Prozessparameterklassifikator (110) ausgelegt ist, um einen Linearitätsindikator basierend auf einem maximalen Eigenwert ($H_{max}$) der Hessematrix (H) zu berechnen und mit einem auf der Jacobimatrix (J) basierenden Vergleichsparameter zu vergleichen, um alle Prozessparameter der Mehrzahl von Prozessparametern der zweiten linearitätsabhängigen Klasse von Prozessparametern zuzuordnen, wenn ein Nicht-Linearitätskriterium nicht erfüllt ist.

11. Vorrichtung gemäß Anspruch 10, wobei der Prozessparameterklassifikator (110) ausgelegt ist, um für jeden Eigen-wert ($\lambda_1$) der Hessematrix (H) einen Linearitätsindikator zu berechnen und mit einem auf der Jacobimatrix (J) basierenden Vergleichsparameter zu vergleichen und einen Eigenwert zu bestimmen, für den der zugehörige Linearitätsindikator ein Nicht-Linearitätskriterium erfüllt, um eine Teilmenge von variierten Prozessparametern der Mehrzahl von Prozessparametern zu bestimmen, von denen zumindest ein Prozessparameter der Teilmenge von variierten Prozessparametern der ersten linearitätsabhängigen Klasse zuzuordnen ist.

12. Vorrichtung gemäß einem der Ansprüche 1 bis 11, die einen Prozesssimulationsdatenbasiskonverter (240) aufweist, der ausgelegt ist, um die bearbeitete Prozesssimulationsdatenbasis (122) auf ein Simulationsgitter für eine Prozesssimulation eines Folgeprozesses zu übertragen, um die Prozesssimulationsdatenbasis (242) für die Prozesssimulation des Folgeprozesses zu erzeugen, wobei das Simulationsgitter von dem Folgeprozess abhängt.

13. Vorrichtung gemäß Anspruch 12, wobei der Prozesssimulationsdatenbasiskonverter (240) ausgelegt ist, um einen Qualitätsparameter zu berechnen, wobei der Qualitätsparameter ein Maß für einen Fehler der Übertragung der bearbeiteten Prozesssimulationsdatenbasis (122) auf das Simulationsgitter der Prozesssimulation des Folgeprozesses ist, wobei der Prozesssimulationsdatenbasiskonverter (240) ausgelegt ist, um die bearbeitete Prozesssimulationsdatenbasis (122) zu übertragen, so dass der Qualitätsparameter kleiner ist als eine maximale Schwankung von Prozesssimulationsdaten in der bearbeiteten Prozesssimulationsdatenbasis (122) unter Variation der Mehrzahl von Prozessparametern.

14. Verfahren (700) zum Bearbeiten einer Prozesssimulationsdatenbasis eines Prozesses, die Prozesssimulationsdaten einer Mehrzahl von Prozesssimulationen des Prozesses umfasst, wobei jede Prozesssimulation der Mehrzahl von Prozesssimulationen auf einer unterschiedlichen Variation einer Mehrzahl von Prozessparametern basiert, wobei für jeden Prozessparameter der Mehrzahl von Prozessparametern für eine initiale Anzahl von unterschiedlichen Prozessparameterwerten Prozesssimulationsdaten einer Prozesssimulation in der Prozesssimulationsdatenbasis enthalten sind, mit folgenden Schritten:

Berechnen (710) eines Linearitätsindikators für einen variierten Prozessparameter der Mehrzahl von Prozessparametern, wobei der Linearitätsindikator basierend auf einer Analyse der Prozesssimulationsdatenbasis bezüglich einer Linearität eines Einflusses einer Variation zumindest des variierten Prozessparameters auf die Prozesssimulationsdaten in der Prozesssimulationsdatenbasis berechnet wird; und
Verändern (720) der initialen Anzahl von unterschiedlichen Prozessparameterwerten des variierten Prozessparameters, für die Prozesssimulationsdaten einer Prozesssimulation in der Prozesssimulationsdatenbasis enthalten sind, um eine bearbeitete Prozesssimulationsdatenbasis zu erhalten, wobei die initiale Anzahl von unterschiedlichen Prozessparameterwerten des variierten Prozessparameters basierend auf dem berechneten Linearitätsindikator verändert wird.

15. Computerprogramm mit einem Programmcode zur Durchführung des Verfahrens gemäß Anspruch 14, wenn das Computerprogramm auf einem Computer oder Mikrocontroller abläuft.

**Claims**

1. An apparatus (100, 200, 300) for processing a process simulation database (102) of a process, including process simulation data of a plurality of process simulations of the process, wherein each process simulation of the plurality of process simulations is based on a different variation of a plurality of process parameters, wherein for each process parameter of the plurality of process parameters, for an initial number of different process parameter values, process simulation data of a process simulation are included in the process simulation database (102), comprising:

a process parameter classifier (110) that is implemented to calculate a linearity indicator for a varied process parameter of the plurality of process parameters based on an analysis of the process simulation database (102) with respect to a linearity of an influence of a variation of at least the varied process parameter on the process simulation data in the process simulation database; and

a process simulation data processor (120) that is implemented to change the initial number of different process parameter values of the varied process parameter, for which process simulation data of a process simulation are included in the process simulation database (102), based on the calculated linearity indicator to obtain a processed process simulation database (122).

**2.** The apparatus according to claim 1, wherein the process parameter classifier (110) is implemented to allocate the varied process parameter to a first linearity-dependent class of process parameters when a calculated linearity indicator of the varied process parameter fulfills a predefined non-linearity criterion, or the process parameter classifier (110) is implemented to allocate the varied process parameter to a second linearity-dependent class of process parameters when the calculated linearity indicator of the varied process parameter does not fulfill the predefined non-linearity criterion, wherein a process parameter that is allocated to the first linearity-dependent class of process parameters has a stronger non-linear influence on the process simulation data in the process simulation database (102) than a process parameter that is allocated to the second linearity-dependent class of process parameters.

**3.** The apparatus according to claim 2, wherein the process simulation data processor (120) is implemented to change the initial number of different process parameter values of the varied process parameter such that a changed number of different process parameter values of the varied process parameter is smaller when the varied process parameter is allocated to the second linearity-dependent class of process parameters than a changed number of different process parameter values of the varied process parameter when the varied process parameter is allocated to the first linearity-dependent class of process parameters.

**4.** The apparatus according to one of claims 1 to 3, wherein the process parameter classifier (110) is implemented to calculate, for the varied process parameter, an influence intensity indicator based on an analysis of the process simulation database (102) with respect to intensity of an influence of a variation at least of the varied process parameter on the process simulation data in the process simulation database (102), and is implemented to allocate the varied process parameter to a first influence-dependent class of process parameters, when the influence intensity indicator fulfills a minimum influence criterion, or to allocate the varied process parameter to a second influence-dependent class of process parameters when the influence intensity indicator does not fulfill the minimum influence criterion, wherein a process parameter that is allocated to the first influence-dependent class of process parameters has a stronger influence on the process simulation data in the process simulation database than a process parameter that is allocated to the second influence-dependent class of process parameters.

**5.** The apparatus according to claim 4, wherein the process simulation data processor (120) is implemented to change the initial number of different process parameter values of the varied process parameter such that a changed number of different process parameter values of the varied process parameter is smaller when the varied process parameter is allocated to the second influence-dependent class of process parameters than a changed number of different process parameter values of the varied process parameter when the varied process parameter is allocated to the first influence-dependent class of process parameters.

**6.** The apparatus according to claims 4 or 5, wherein the process parameter classifier (110) is implemented to allocate, at first, the varied process parameter to the first linearity-dependent class or the second linearity-dependent class and then the varied process parameter to the first influence-dependent class or the second influence-dependent class, when the varied process parameter has first been allocated to the second linearity-dependent class.

**7.** The apparatus according to claim 6, wherein the process simulation data processor (120) is implemented to reduce the initial number of different process parameter values of the varied process parameter to two different process parameter values of the varied process parameter, for which process simulation data of a process simulation are included in the process simulation database, when the varied process parameter is allocated to the second linearity-dependent class of process parameters and the first influence-dependent class of process parameters, or the process simulation data processor (120) is implemented to reduce the initial number of different process parameter values of the varied process parameter to a single process parameter value of the varied process parameter, for which process simulation data of a process simulation are included in the process simulation database, when the varied process parameter is allocated to the second linearity-dependent class and the second influence-dependent class.

**8.** The apparatus according to one of claims 1 to 7, wherein the process parameter classifier (110) is implemented to calculate the linearity indicator of the varied process parameter based on a Hessian (H), wherein the Hessian (H) indicates a measure for the second-order partial derivative of the process simulation data under variation of the plurality of process parameters.

9. The apparatus according to claim 8, wherein the process parameter classifier (110) is implemented to calculate a Jacobian matrix (J), wherein the Jacobian matrix (J) indicates a measure for the first derivative of the process simulation data under variation of the plurality of process parameters, wherein the process parameter classifier (110) is implemented to allocate the varied process parameter, based on a comparison of a comparison parameter based on the Jacobian matrix (J) with the linearity indicator based on the Hessian (H), to the first linearity-dependent class of process parameters or to the second linearity-dependent class of process parameters.

10. The apparatus according to claim 9, wherein the process parameter classifier (110) is implemented to calculate a linearity indicator based on a maximum eigenvalue ($H_{max}$) of the Hessian (H) and to compare the same to a comparison parameter based on the Jacobian matrix (J), to allocate all process parameters of the plurality of process parameters to the second linearity-dependent class of process parameters when a non-linearity criterion is not fulfilled.

11. The apparatus according to claim 10, wherein the process parameter classifier (110) is implemented to calculate a linearity indicator for each eigenvalue ($\lambda_1$) of the Hessian (H) and to compare the same to a comparison parameter based on the Jacobian matrix (J) and to determine an eigenvalue for which the allocated linearity indicator fulfills a non-linearity criterion, to determine a subset of varied process parameters of the plurality of process parameters of which at least one process parameter of the subset of varied process parameters is to be allocated to the first linearity-dependent class.

12. The apparatus according to one of claims 1 to 11, comprising a process simulation database converter (240) that is implemented to map the processed process simulation database (122) to a simulation grid for process simulation of a follow-up process in order to generate the process simulation database (242) for the process simulation of the follow-up process, wherein the simulation grid depends on the follow-up process.

13. The apparatus according to claim 12, wherein the process simulation database converter (240) is implemented to calculate a quality parameter, wherein the quality parameter is a measure for an error of the mapping of the processed process simulation database (122) to the simulation grid of the process simulation of the follow-up process, wherein the process simulation database converter (240) is implemented to map the processed process simulation database (122) such that the quality parameter is smaller than a maximum variation of process simulation data in the processed process simulation database (122) under variation of the plurality of process parameters.

14. A method (700) for processing a process simulation database of a process comprising process simulation data of a plurality of process simulations of the process, wherein each process simulation or the plurality of process simulations is based on a different variation of a plurality of process parameters, wherein, for each process parameter of the plurality of process parameters, for an initial number of different process parameter values, process simulation data of a process simulation are included in the process simulation database, comprising:

calculating (710) a linearity indicator for a varied process parameter of the plurality of process parameters, wherein the linearity indicator is calculated based on an analysis of the process simulation database with respect to a linearity of an influence of a variation of at least the varied process parameter on the process simulation data in the process simulation database; and
changing (720) the initial number of different process parameter values of the varied process parameter, for which process simulation data of a process simulation are included in the process simulation database, to obtain a processed process simulation database, wherein the initial number of different process parameter values of the varied process parameter is changed based on the calculated linearity indicator.

15. A computer program having a program code for performing the method according to claim 14 when the computer program runs on a computer or a microcontroller.

**Revendications**

1. Dispositif (100, 200, 300) de traitement d'une base de données de simulation d'un processus (102) d'un processus qui comporte les données de simulation de processus d'une pluralité de simulations du processus, chaque simulation de processus de la pluralité de simulations de processus se basant sur une variation différente d'une pluralité de paramètres de processus, pour chaque paramètre de processus de la pluralité de paramètres de processus pour un nombre initial de valeurs de paramètre de processus différentes étant contenues des données d'une simulation de processus d'une simulation de processus dans la base de données de simulation de processus (102), aux caractéristiques suivantes:

un classificateur de paramètres de processus (110) qui est conçu pour calculer, pour un paramètre de processus varié de la pluralité de paramètres de processus, un indicateur de linéarité sur base d'une analyse de la base de données de simulation de processus (102) par rapport à une linéarité d'une influence d'une variation au moins du paramètre de processus varié sur les données de simulation de processus dans la base de données de simulation de processus; et

un moyen de traitement de données de simulation de processus (120) qui est conçu pour modifier le nombre initial de valeurs de paramètre de processus différentes du paramètre de processus varié pour lesquelles les données d'une simulation de processus d'une simulation de processus sont contenues dans la base de données de simulation de processus (102) sur base de l'indicateur de linéarité calculé, pour obtenir une base de données de simulation de processus traitée (122).

2. Dispositif selon la revendication 1, dans lequel le classificateur de paramètres de processus (110) est conçu pour associer le paramètre de processus varié à une première classe de paramètres de processus fonction de la linéarité lorsqu'un indicateur de linéarité calculé du paramètre de processus varié remplit un critère de non-linéarité prédéfini, ou le classificateur de paramètres de processus (110) est conçu pour associer le paramètre de processus varié à une deuxième classe de paramètres de processus fonction de la linéarité lorsque l'indicateur de linéarité calculé du paramètre de processus varié ne remplit pas le critère de non-linéarité prédéfini, un paramètre de processus associé à la première classe de paramètres de processus fonction de la linéarité présentant une plus grande influence non linéaire sur les données de simulation de processus dans la base de données de simulation de processus (102) qu'un paramètre de processus qui est associé à la deuxième classe de paramètres de processus fonction de la linéarité.

3. Dispositif selon la revendication 2, dans lequel le moyen de traitement de données de simulation de processus (120) est conçu pour changer le nombre initial de valeurs de paramètre de processus différentes du paramètre de processus varié de sorte qu'un nombre varié de valeurs de paramètre de processus différentes du paramètre de processus varié soit plus petit lorsque le paramètre de processus varié est associé à la deuxième classe de paramètres de processus fonction de la linéarité qu'un nombre varié de valeurs de paramètre de processus différentes du paramètre de processus varié lorsque le paramètre de processus varié est associé à la première classe de paramètres de processus fonction de la linéarité.

4. Dispositif selon l'une des revendications 1 à 3, dans lequel le classificateur de paramètres de processus (110) est conçu pour calculer, pour le paramètre de processus varié, un indicateur d'intensité d'influence sur base d'une analyse de la base de données de simulation de processus (102) par rapport à une intensité d'une influence d'une variation au moins du paramètre de processus varié sur les données de simulation de processus dans la base de données de simulation de processus (102), et est conçu pour associer le paramètre de processus varié à une première classe de paramètres de processus fonction de l'influence lorsque l'indicateur d'intensité d'influence remplit un critère d'influence minimum, ou pour associer le paramètre de processus varié à une deuxième classe de paramètres de processus fonction de l'influence lorsque l'indicateur d'intensité d'influence ne remplit pas le critère d'influence minimum, un paramètre de processus associé à la première classe de paramètres de processus fonction de l'influence présentant une plus grande influence sur les données de simulation de processus dans la base de données de simulation de processus qu'un paramètre de processus qui est associé à la deuxième classe de paramètres de processus fonction de l'influence.

5. Dispositif selon la revendication 4, dans lequel le moyen de traitement de données de simulation de processus (120) est conçu pour changer le nombre initial de valeurs de paramètre de processus différentes du paramètre de processus varié de sorte qu'un nombre varié de valeurs de paramètre de processus différentes du paramètre de processus varié soit plus petit lorsque le paramètre de processus varié est associé à la deuxième classe de paramètres de processus fonction de l'influence qu'un nombre varié de valeurs de paramètre de processus différentes du paramètre de processus varié lorsque le paramètre de processus varié est associé à la première classe de paramètres de processus fonction de l'influence.

6. Dispositif selon la revendication 4 ou 5, dans lequel le classificateur de paramètres de processus (110) est conçu pour tout d'abord associer le paramètre de processus varié à la première classe fonction de la linéarité ou à la deuxième classe fonction de la linéarité et ensuite associer le paramètre de processus varié à la première classe d'influence ou à la deuxième classe fonction de l'influence lorsque le paramètre de processus varié a tout d'abord été associé à la deuxième classe fonction de la linéarité.

7. Dispositif selon la revendication 6, dans lequel le moyen de traitement de données de simulation de processus (120) est conçu pour réduire le nombre initial de valeurs de paramètre de processus différentes du paramètre de processus varié à deux valeurs de paramètre de processus différentes du paramètre de processus varié pour lesquelles des données d'une simulation de processus sont contenues dans la base de données de simulation de processus lorsque le paramètre de processus varié est associé à la deuxième classe de paramètres de processus fonction de la linéarité et à la première classe de paramètres de processus fonction de l'influence, ou le moyen de traitement de données de simulation de processus (120) est conçu pour réduire le nombre initial de valeurs de paramètre de processus différentes du paramètre de processus varié à une seule valeur du paramètre de processus varié pour laquelle des données d'une simulation de processus sont contenues dans la base de données de simulation processus lorsque le paramètre de processus varié est associé à la deuxième classe fonction de la linéarité et la deuxième classe fonction de l'influence.

8. Dispositif selon l'une des revendications 1 à 7, dans lequel le classificateur de paramètres de processus (110) est conçu pour calculer l'indicateur de linéarité du paramètre de processus varié sur base d'une matrice de Hesse (H), la matrice de Hesse (H) indiquant une mesure de la dérivation partielle de deuxième ordre des données de simulation de processus avec variation de la pluralité de paramètres de processus.

9. Dispositif selon la revendication 8, dans lequel le classificateur de paramètres de processus (110) est conçu pour calculer une matrice jacobienne (J), la matrice jacobienne (J) indiquant une mesure de la première dérivation des données de simulation de processus avec variation de la pluralité de paramètres de processus, le classificateur de paramètres de processus (110) étant conçu pour associer le paramètre de processus varié sur base d'une comparaison d'un paramètre de comparaison basé sur la matrice jacobienne (J) avec l'indicateur de linéarité basé sur la matrice de Hesse (H) à la première classe de paramètres de processus fonction de la linéarité ou à la deuxième classe de paramètres de processus fonction de la linéarité.

10. Dispositif selon la revendication 9, dans lequel le classificateur de paramètres de processus (110) est conçu pour calculer un indicateur de linéarité sur base d'une valeur propre maximale ($H_{max}$) de la matrice de Hesse (H) et à le comparer avec un paramètre de comparaison basé sur la matrice jacobienne (J), pour associer tous les paramètres de processus de la pluralité de paramètres de processus à la deuxième classe de paramètres de processus fonction de la linéarité lorsqu'un critère de non-linéarité n'est pas rempli.

11. Dispositif selon la revendication 10, dans lequel le classificateur de paramètres de processus (110) est conçu pour calculer un indicateur de linéarité pour chaque valeur propre ($\lambda_1$) de la matrice de Hesse (H) et pour le comparer avec un paramètre de comparaison basé sur la matrice jacobienne (J) et pour déterminer une valeur propre pour laquelle l'indicateur de linéarité correspondant remplit un critère de non-linéarité, pour déterminer une quantité partielle de paramètres de processus variés de la pluralité de paramètres de processus parmi lesquels au moins un paramètre de processus de la quantité partielle de paramètres de processus variés doit être associé à la première classe fonction de la linéarité.

12. Dispositif selon l'une des revendications 1 à 11, présentant un convertisseur de base de données de simulation de processus (240) qui est conçu pour transmettre la base de données de simulation de processus traitée (122) à une grille de simulation pour une simulation de processus d'un processus suivant, pour générer la base de données de simulation de processus (242) pour la simulation du processus suivant, la grille de simulation dépendant du processus suivant.

13. Dispositif selon la revendication 12, dans lequel le convertisseur de base de données de simulation de processus (240) est conçu pour calculer un paramètre de qualité, le paramètre de qualité étant une mesure d'une erreur de transmission de la base de données de simulation de processus traitée (122) à la grille de la simulation de processus du processus suivant, dans lequel le convertisseur de base de données de simulation de processus (240) est conçu pour transmettre la base de données de simulation de processus traitée (122) de sorte que le paramètre de qualité soit inférieur à une variation maximale des données simulation de processus dans la base de données de simulation de processus traitée (122) avec variation de la pluralité de paramètres de processus.

14. Procédé (700) pour traiter une base de données de simulation de processus d'un processus qui comporte les données de simulation de processus d'une pluralité de simulations du processus, chaque simulation de processus de la pluralité de simulations de processus étant basée sur une variation différente d'une pluralité de paramètres de processus, pour chaque paramètre de processus de la pluralité de paramètre de processus pour un nombre initial de valeurs de paramètre de processus différentes sont contenues dans la base de données de simulation de processus des données de simulation de processus d'une simulation de processus, aux étapes suivantes:

calculer (710) un indicateur de linéarité pour un paramètre de processus varié de la pluralité de paramètres de processus, l'indicateur de linéarité étant calculé sur base d'une analyse de la base de données de simulation de processus par rapport à une linéarité d'une influence d'une variation au moins du paramètre de processus varié sur les données de simulation de processus dans la base de données de simulation de processus; et modifier (720) le nombre initial de valeurs différentes du paramètre de processus du paramètre de processus varié pour lesquelles des données d'une simulation de processus d'une simulation de processus sont contenues dans la base de données de simulation de processus, pour obtenir une base de données de simulation de processus traitée, le nombre initial de valeurs différentes du paramètre de processus du paramètre de processus varié étant modifié sur base de l'indicateur de linéarité calculé.

15. Programme d'ordinateur avec un code de programme pour réaliser le procédé selon la revendication 14 lorsque le programme d'ordinateur est exécuté sur un ordinateur ou un microcontrôleur.

100

102

Prozessparameterklassifikator

110

Prozesssimulationsdatenbearbeiter

120

122

FIG 1

─200

```
            │
            ▼
    ┌───────────────┐
    │   Prozess-    │  ─230
    │   simulator   │
    └───────────────┘
            │  ─102
            ▼
    ┌───────────────┐
    │   Prozess-    │  ─110
    │  parameter-   │
    │  klassifikator│
    └───────────────┘
            │
            ▼
    ┌───────────────┐
    │   Prozess-    │
    │ simulations-  │  ─120
    │    daten-     │
    │  bearbeiter   │
    └───────────────┘
            │  ─122
            ▼
    ┌───────────────┐
    │   Prozess-    │
    │ simulations-  │
    │ datenbasis-   │  ─240
    │  konverter    │
    └───────────────┘
            │  ─242
            ▼
```

# FIG 2

—300

↓ —102

Prozess-
simulationsdatenanpasser —350

Prozessparameter-
klassifikator —110

Prozess-
simulationsdatenbearbeiter —120

—122

FIG 3

# FIG 4

Simultane Konstruktion und Kompression der Datenbasis, z.B. mittels Singulärwertzerlegung

Anzahl der Simulationen

sim1 ... sim2 simN

Anzahl der Knoten / Elemente

X = U * W * $V^T$

EP 2 433 185 B1

**Ausgabe der Umformsimulationen**

... Interpolation ... = X

510 510 520 520

**Simulationsergebnisse**
Pro Kriterium:
Funktionale der lokalen
Verteilungen können
unterschiedliche Länge
besitzen

**Simulationsergebnisse**
Pro Kriterium:
Funktionale derselben
Länge dienen als Eingabe
zur Konstruktion der
Datenbasis

# FIG 5

Metallblech

Umform-simulationen

Eingabe: Material- und Prozessparameter zusammen mit ihren Schwankungs- informationen (Bereich pro Parameter, Verteilungsfunktion), **design of experiments** (Entwurf des Experiments)

Ausgabe: **Simulationsergebnisse** Funktionale der lokalen Verteilungen gewählter Kriterien, z.B. Blechdicken, Spannungen, Schädigungen etc. zusammen mit ihren Schwankungsinformationen, auf dem Gitter der Umformsimulationen

Konstruktion und Kompression der Datenbasis (s. Fig. 4 und 5)

Abbildung der konstruierten Datenbasis

Eingabe: Funktionale auf dem, für die Unfallsimulationen genutzten Gitter, die Verteilungen der gewählten Kriterien und ihre Schwankungsinformationen können aus diesen rekonstruiert werden

Unfall-simulationen

Ausgabe: Dtenbasis der Verteilungen oder Optimierungskriterien, mit ihren Schwankungs- informationen

FIG 6

—700

Berechnen eines Linearitätsindikators für einen variierten Prozessparameter der Mehrzahl von Prozessparametern, wobei der Linearitätsindikator basierend auf einer Analyse der Prozesssimulationsdatenbasis bezüglich einer Linearität eines Einflusses einer Variation zumindest des variierten Prozessparameters auf die Prozesssimulationsdaten in der Prozesssimulationsdatenbasis berechnet wird.

710

Verändern der initialen Anzahl von unterschiedlichen Prozessparameterwerten des variierten Prozessparameters, für die Prozesssimulationsdaten einer Prozesssimulation in der Prozesssimulationsdatenbasis enthalten sind, um eine bearbeitete Prozesssimulationsdatenbasis zu erhalten, wobei die initiale Anzahl von unterschiedlichen Prozessparameterwerten des variierten Prozessparameters basierend auf dem berechneten Linearitätsindikator verändert wird.

720

FIG 7

**EP 2 433 185 B1**

**IN DER BESCHREIBUNG AUFGEFÜHRTE DOKUMENTE**

**In der Beschreibung aufgeführte Patentdokumente**

- US 20090089030 A